(19) Europäisches Patentamt
European Patent Office
Office européen des brevets

(11) **EP 1 995 758 B1**

(12) **EUROPÄISCHE PATENTSCHRIFT**

(45) Veröffentlichungstag und Bekanntmachung des Hinweises auf die Patenterteilung:
**20.06.2012 Patentblatt 2012/25**

(51) Int Cl.:
*H01J 37/05* (2006.01)  *H01J 37/153* (2006.01)
*H01J 37/26* (2006.01)  *H01J 49/48* (2006.01)

(21) Anmeldenummer: **08008712.5**

(22) Anmeldetag: **09.05.2008**

(54) **Monochromator und Teilchenstrahlquelle mit Monochromator**

Monochromator and charged particle beam source with monochromator

Monochromateur et source de faisceau de particules chargées dotée d'un tel monochromateur

(84) Benannte Vertragsstaaten:
**CZ DE GB NL**

(30) Priorität: **24.05.2007 DE 102007024353**

(43) Veröffentlichungstag der Anmeldung:
**26.11.2008 Patentblatt 2008/48**

(73) Patentinhaber: **Ceos Corrected Electron Optical Systems GmbH**
**69126 Heidelberg (DE)**

(72) Erfinder: **Uhlemann, Stephan, Dr.**
**69115 Heidelberg (DE)**

(74) Vertreter: **Weber, Walter**
**Weber & Seidel**
**Rechts- und Patentanwälte**
**Handschuhsheimer Landstrasse 2a**
**69120 Heidelberg (DE)**

(56) Entgegenhaltungen:
**US-A- 3 863 068     US-A1- 2002 017 614**
**US-A1- 2004 188 607**

• **ANDERSEN W H J ET AL: "A double wienfilter as a high resolution, high transmission electron energy analyser" JOURNAL OF PHYSICS E. SCIENTIFIC INSTRUMENTS, IOP PUBLISHING, BRISTOL, GB LNKD- DOI: 10.1088/0022-3735/3/2/309, Bd. 3, Nr. 2, 1. Februar 1970 (1970-02-01) , Seiten 121-126, XP020019619 ISSN: 0022-3735**

EP 1 995 758 B1

## EP 1 995 758 B1

**Beschreibung**

Die Erfindung betrifft einen Monochromator für eine Ladungsteilchenoptik, insbesondere für die Elektronenmikroskopie, mit mindestens einem ersten Ablenkelement mit einem elektrostatischen Ablenkfeld zur Erzeugung einer Dispersion in einer Ebene mit einer Selektionsblende zur Selektion der Ladungsteilchen des gewünschten Energieintervalls und mindestens einem zweiten Ablenkelement mit einem elektrostatischen Ablenkfeld, das die Dispersion des mindestens einen ersten Ablenkfeldes eliminiert.

Chromatische Aberration ist einer der Hauptfaktoren, der durch die dadurch hervorgerufene Verbreiterung der Ladungsteilchenstrahlen aufgrund der Breite des Energiespektrums und des Farbfehlers der Linsen die Auflösung in der Ladungsteilchenoptik begrenzt. Der Zweck von Monochromatoren besteht darin, diese chromatische Aberration zu begrenzen. Beispielsweise darf in der Elektronenmikroskopie bei einer Beschleunigungsspannung von 200 kV die Energiebreite von 0,2 eV nicht überschritten werden, um eine Auflösung von weniger als 1 Angström zu erzielen. Als Elektronenquellen mit den geringsten Halbwertsbreiten gelten thermisch unterstützte Feldemissionskathoden, bei denen die Energiehalbwertsbreite jedoch immer noch 0,6 bis 1,0 eV beträgt. Untersuchungen haben gezeigt, daß etwas 30 % der Elektronen eine Abweichung von weniger als 0,1 eV besitzen. Für bestimmte Anwendungen, wie bei Transmissions- oder Rasterelektronenmikroskopen sind geringe Stromstärken ausreichend, so daß das Herausfiltern von ca. 70 % der Elektronen ein gangbarer Weg zur Realisierung einer hinreichend monochromatischen Elektronenquelle mit ausreichender Stromstärke darstellt. Daher können Monochromatoren zum Einsatz kommen.

Im Gegensatz zu solchen durch Filterung mittels eines Monochromators erzielten monochromatischen Elektronenquellen gibt es auch noch abbildende Energiefilter zur Erzeugung eines achromatischen Bildes einer Probe. Ein solcher abbildender Energiefilter ist aus der DE 10 2005 031 537 A1 bekannt. Das achromatische Bild der Probe wird durch ein im Wesentlichen kreisförmiges Ablenkelement erzeugt, indem die geladenen Teilchen zu niedriger Energie in die Abschirmung und die zu hoher Energie gegen eine Blende gelenkt werden. Bei dem Monochromator, dessen Verbesserung die Erfindung zum Ziel hat, geht es jedoch nicht darum, das Bild einer Probe energetisch zu filtern, sondern darum, den Beleuchtungsstrahl vor der Beleuchtung einer Probe zu monochromatisieren.

Aus der EP 0 470 299 B1 ist ein Monochromator der letztgenannten Art bekannt, bei dem als Ablenkelemente halbkugelförmige Kondensatoren mit inneren und äußeren hemisphärischen Elektroden dienen, die an verschiedene Potentiale angeschlossen sind. Die Ablenkelemente sind spiegelsymmetrisch zu einer Mittelebene angeordnet, in der sich eine Selektionsblende zum Ausblenden von Elektronen abweichender Energie befindet. Durch die Ausgestaltung der Ablenkelemente als halbkugelförmige Kondensatoren kommt es dazu, daß Ladungsteilchen, die gegenüber der optischen Achse in verschiedene Richtungen ausgelenkt sind, immer wieder zu Punkten fokussiert werden. Der Hintergrund ist der, daß die Ablenkung der Ladungsteilchen in einem Kugelfeld stattfindet, das die Ladungsteilchen aller Schnitte durch den Strahlengang in gleichem Maße beeinflußt, so daß die entstehenden Zwischenbilder der Strahlenquelle punktförmig sind. Dabei werden vor und hinter der Selektionsblende zwei dieser Punktfokussierungen und in der Öffnung der Selektionsblende eine Punktfokussierung gebildet.

Aus der US 2004/0188607 A1 ist ein Monochromator bekannt, der ähnlich wie der letztgenannte eine $\Omega$-Form aufweist, bei der die Bögen dieser Form jedoch von der Halbkugelform etwas abweichen. Die Gestaltung ist allerdings der Art, daß immer noch an drei Stellen, außer am Ort der Selektionsblende auch im ersten Ablenkfeld sowie im letzten Ablenkfeld der $\Omega$-Form, punktförmige Zwischenbilder der Strahlquelle entstehen, da dort beide Fundamentalbahnen ($x_\alpha$ und $y_\beta$) zu Null werden.

Bei derartigen Punktfokussierungen treffen sich jedoch nur Ladungsteilchen gleicher Energie in einem Punkt. Durch unterschiedliche Energien der Ladungsteilchen reihen sich die Punkte der Ladungsteilchen unterschiedlicher Energien aneinander und bilden so einen Strich, so daß es möglich ist, mit der Selektionsblende die Ladungsteilchen mit zu hoher und zu niedriger Energie abzuschirmen und nur Ladungsteilchen des gewünschten Energieintervalls durchzulassen. Dieses Energieintervall wird dann nach der Selektionsblende durch die nachgeschalteten Ablenkelemente wieder vereinigt; die Dispersion durch die vorgeschalteten Ablenkelemente wird also wieder eliminiert.

Der Nachteil von Monochromatoren der oben beschriebenen Art mit punktförmigen Zwischenbildern der Strahlquelle besteht darin, daß sich Ladungsteilchen um so mehr gegenseitig beeinflussen, je enger sie zusammengeführt werden. Dieser Boersch-Effekt wirkt dem Bestreben, eine möglichst hohe Monochromasie zu erzielen, entgegen. Ladungsteilchen stoßen sich gegenseitig ab, so daß es zu Bremsungen und Beschleunigung mit einer zusätzlichen Dispersionswirkung kommt; man spricht davon, daß sich die virtuelle Quellgröße vergrößert. Ein Monochromator ist so aufgebaut, daß er in dem Teil, der nach der Selektionsblende liegt, die Dispersion des Teils, der vor der Selektionsblende liegt, wieder eliminiert. Er kann somit die Ortsveränderungen, die er durch seine Ablenkfelder herbeiführt, wieder rückgängig machen, jedoch nicht solche Ortsveränderungen, die durch die gegenseitige Beeinflussung der Ladungsteilchen herrühren. Diese beeinträchtigt die Monochromasie und somit die Fokussierbarkeit des Strahls, was dann wiederum die Auflösung der Optik beeinträchtigt.

Ausgehend vom vorgenannten und ähnlichen Monochromatoren mit Punktfokussierungen (stigmatische Zwischenbilder) wurde in der Dissertationsarbeit "Design eines Monochromators für Elektronenquellen" von Frank Kahl

2

(http://elib.tu-darmstadt.de /diss/000030) ein Monochromator der eingangs genannten Art vorgeschlagen, bei dem die Ablenkelemente derart ausgebildet werden, daß die Ladungsteilchen eines x- und y-Schnittes unterschiedliche Bahnen beschreiben und daß mehrere Bilder einer Strahlquelle ausschließlich als astigmatische Zwischenbilder in Form von Linienfokussen auftreten. Dabei dient jedoch lediglich das dispersive astigmatische Bild in der Symmetrieebene zur Selektion der Ladungsteilchen des gewünschten Energieintervalls. Da dieses dispersive Bild astigmatisch ist, muß dazu eine Schlitzblende verwendet werden. Der vorgeschlagene Monochromator führte auch zum Patent DE 196 33 496 B4.

In dieser Dissertationsarbeit wurden bisher vorgeschlagene Monochromatoren unter 3.1 (Seiten 25 bis 27) vorgestellt, unter anderem der Monochromator von Rose (3.1.3), welcher dem der EP 0 470 299 B1 entspricht (a.a.O., Seiten 26 und 27). Als Monochromatoren werden auch Wienfilter eingesetzt, wie dies beispielsweise aus W H J Andersen und J B Le Pool: "A double wienfilter as a high resolution, high transmission electron energy analyser", Journal of Physics e. Scientific Instruments, IOP Publishing, Bristol, GB, LNKD- DOI:10.1088/0022-3735/3/2/309, Bd. 3, Nr. 2, 1. Februar 1970, Seiten 121-126, XP020019619 bekannt ist. Der Wienfilter besteht aus zu einander senkrechten elektrostatischen und magnetischen Feldern. In der Dissertationsarbeit von Frank Kahl wird auch der Einsatz von Wienfiltern diskutiert (a.a.O., Seiten 25 und 26), die drei stigmatische Zwischenbilder der Strahlquelle aufweisen. Außerdem wird darauf hingewiesen, daß die große Baulänge der Wienfilter und die Verwendung magnetischer Elemente von Nachteil ist (a.a.O., Seite 25-26). Unter 10.2.3 (Seiten 144 bis 148) wurden stigmatischer und astigmatischer Strahlengang verglichen und festgestellt, daß es bei mehreren stigmatischen Zwischenbildern (Punktfokussen) zu einer vielfach größeren Quellvergrößerung kommt als bei astigmatischen Zwischenbildern (Linienfokussen). Bezüglich der letzteren wurde als "worst case" eine Vergrößerung der Quellfläche um den Faktor 7 angegeben, beim System von Rose dagegen als "worst case" eine Vergrößerung der Quellfläche um den Faktor 60 (a.a.O, S. 148).

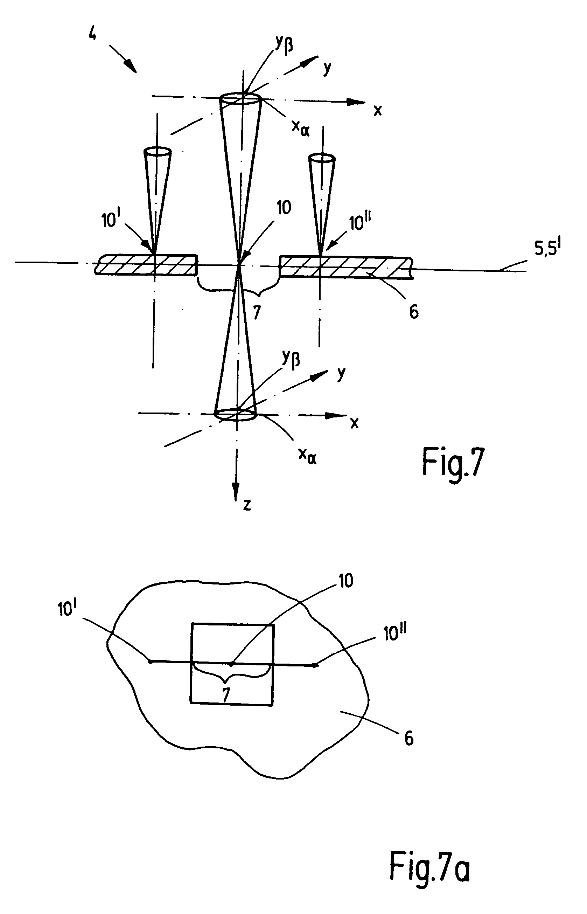

Da alle vorbekannten Monochromatoren den nachteiligen Boersch-Effekt der Punktfokusse (stigmatische Zwischenbilder) aufweisen, mußte der Strahlstrom auf 10nA begrenzt werden (a.a.O., S. 28). Dies ist wiederum von Nachteil, da eine Steigerung der Auflösung große Beleuchtungsströme in Verbindung mit einer geringen Energiebreite der Quelle voraussetzt. Zur Überwindung dieser Beschränkung wurde vorgeschlagen, ausschließlich astigmatische reelle Zwischenbilder der Quelle zuzulassen (a.a.O. 3.2, Seite 28), also Linienfokusse. Linienfokus bedeutet, daß die Ladungsteilchen einer Energie in den Zwischenbildern die Strahlenquelle nicht als Punkt, sondern als Linie abgebildet werden. Diese Linienfokusse sind in einer Darstellung der Fundamentalbahnen der Abbildung 7.3, (a.a.O., Seite 85) enthalten.

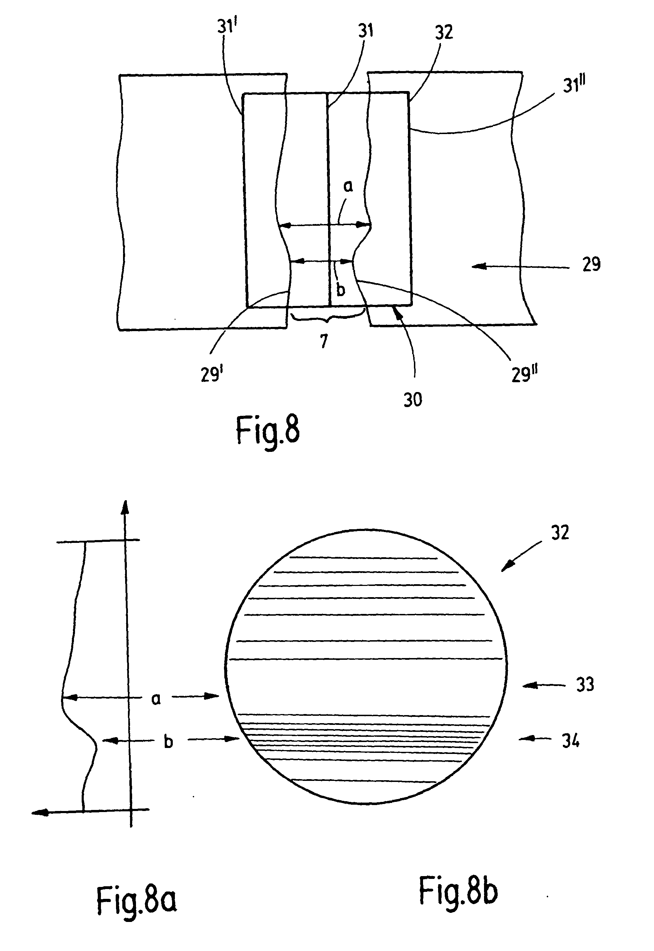

Die Linienfokusse werden durch die verschiedenen Energien entsprechend der Dispersion verbreitert, so daß in der für die Selektion genutzten Fokusebene ein Strahl entsteht, der im Wesentlichen einen viereckigen Querschnitt aufweist. Um bei diesem Fokus ein gewünschtes Energieintervall zu selektieren, ist es erforderlich, Ladungsteilchen mit abweichenden Energien abzuschirmen und nur die Linienfokusse des gewünschten Energieintervalls durch die Blende zu lassen. Dazu ist wegen der Linienfokusse eine in deren Richtung ausgerichtete Schlitzblende erforderlich, deren Breite das ausgewählte Energieintervall bestimmt (siehe Fig. 8).

Dieser Monochromator vermeidet zwar den starken Boersch-Effekt der stigmatischen Zwischenbilder, der Nachteil dieses Monochromators besteht jedoch darin, daß jede Unebenheit oder Verschmutzung des Schlitzes der Blende ebenfalls auf den Ladungsteilchenstrom wirkt, was zu Streuungen führt und sich im Endbild des optischen Systems als Intensitätsunterschiede auswirkt, die sich streifenförmig über das Bild ziehen (siehe Fig. 8a und 8b). Die Empfindlichkeit diesbezüglich ist so groß, daß sich dieser Fehler durch mechanische Präzision und Vermeidung von Schmutzablagerungen nicht vermeiden läßt. Dies führt insbesondere bei Objekten mit geringem Intensitätskontrast, wie dünnen Kristallen, dazu, daß sich die Intensitätskontraste des Objekts mit den Intensitätskontrasten dieses Fehlers überlagern, was zu Streifen im Bild führt, die oftmals eine Bildauswertung unmöglich machen.

Ein solcher Monochromator ist auch aus der DE 100 20 382 A1 bekannt, der in einer dispersiven Ebene ein astigmatisches Zwischenbild der Strahlquelle erzeugt, wobei in dieser Ebene eine Schlitzblende mit einer Orientierung des Schlitzes in Richtung der Längsausdehnung des astigmatischen Zwischenbildes angeordnet ist, wie dies unten in den Figuren 8, 8a und 8b dargestellt und ausführlich beschrieben ist.

Auch die DE 102 52 129 A1 lehrt einen Monochromator, der mit Schlitzblenden im Bereich astigmatischer Zwischenbilder arbeitet. Zwei solche gegeneinander um 180° oder einem abweichenden Winkel verdrehte astigmatische Zwischenbilder entstehen bei dieser Anordnung beim Strahleintritt und -austritt einer Transfereinrichtung, welche zwischen punktsymmetrisch, S-förmig angeordneten Energieanalysatoren eingefügt ist. Auch diese Schlitzblenden weisen den schon erwähnten Nachteil auf.

Das Dokument US3863068 offenbart in "Example 2" (Spalte 6, Zeilen 20 ff.) ein rein elektrostatisches System mit einem einzigen stigmatischen Zwischenbild (20) am Ort einer Blende (22) zur Energieselektion, jedoch mit sphärischen Elektroden (als Spezialfall einer toroidalen Anordnung mit Bahnradius r gleich Elektrodenradius R - Gleichung (11) und Spalte 4, Z. 37: c=r/R=1).

Der Erfindung liegt daher die Aufgabe zugrunde, einen Monochromator der eingangs genannten Art derart auszugestalten, daß eine möglichst hohe Monochromasie ohne fehlerbedingte Intensitätskontraste erzielbar ist.

Die Aufgabe wird erfindungsgemäß dadurch gelöst, daß die Ablenkelemente derart von einer sphärischen Form abweichend ausgebildet und ihre Elektroden mit einem derartigen Potential beaufschlagt sind, daß die axialen Fundamentalbahnen der Ladungsteilchen, die in verschiedenen Schnitten jeweils unter einem Winkel virtuell in ein stigmatisches Bild mit einem Nulldurchgang beider Fundamentalbahnen einer Strahlquelle einlaufen, derart unterschiedlich fokussiert werden, daß es ausschließlich in der Ebene der Selektionsblende zu einem stigmatischen Bild der Strahlquelle mit einer Punktfokussierung von Ladungsteilchen einer Energie kommt, da im gesamten Monochromator nur dort Nulldurchgänge der axialen Fundamentalbahnen der Ladungsteilchen der verschiedenen Schnitte bei der gleichen Achsposition aufeinandertreffen.

Wie oben zur EP 0 470 299 B1 beschrieben, wird auch bei der Erfindung Punktfokussierung und Dispersion im Bereich der Selektionsblende dazu genutzt, nur Elektronen des gewünschten Energieintervalls durch die Selektionsblende zu lassen (siehe Fig. 7 und 7a) und danach die in dem der Selektionsblende vorgeschalteten Teil des Monochromators herbeigeführte Dispersion im nachgeschalteten Teil des Monochromators wieder zu eliminieren. Ein solches Eliminieren kann auf zwei Arten erfolgen, entweder dadurch, daß die Ladungsteilchen auf einen Punkt zusammengeführt werden und nur in diesem Punkt eliminiert sind, oder daß eine vollständige Vereinigung, also wieder ein Gleichlauf hergestellt wird. Vorzugsweise wird letzteres bewirkt, indem die Kräfte des nachgeschalteten Teils des Monochromators den Kräften des vorgeschalteten entsprechen, jedoch entgegengesetzt gerichtet sind.

Der Grundgedanke der Erfindung besteht darin, sowohl die oben beschriebenen Ablenkungen von Ladungsteilchen durch die Schlitzblende zu vermeiden, als auch die Verschlechterung der Monochromasie durch den Boersch-Effekt auf ein Minimum zu reduzieren. Um vom Einsatz einer Schlitzblende wegzukommen, mußte man Punktfokussierungen der verschiedenen Energien im Bereich der Selektionsblende erzeugen, so daß das gewünschte Energieintervall von den abweichenden Energien mittels einer Blende getrennt werden kann. Da der Ladungsteilchenstrom durch den Punktfokus im Bereich des Herausschneidens der abweichenden Energien nur eine ganz geringe Ausdehnung aufweist, kommen Unebenheiten und Verschmutzungen des Randes der zum Einsatz kommenden Blendenöffnung nicht zum Tragen. Jedoch mußte verhindert werden, daß es zu weiteren Punktfokussierungen kommt, damit der Boersch-Effekt der Punktfokussierung auf die einzige Punktfokussierung im Bereich der Selektionsblende beschränkt bleibt. Daher ist es nicht möglich, Kugelfelder, wie von der EP 047 0299 B 1 vorgeschlagen, einzusetzen, welche mit fünf stigmatischen Zwischenbildern (a.a.O., S. 26) zu der erheblichen Vergrößerung der Quellfläche führen (a.a.O., S. 148).

Die Ablenkelemente müssen somit zwar, wie von Kahl (a.a.O.) vorgeschlagen, derart ausgebildet werden, daß sie Ladungsteilchen, die von der optischen Achse in verschiedenen Richtungen entfernt sind, sich also in verschiedenen Schnitten, wie beispielsweise im x-Schnitt oder im y-Schnitt, befinden, unterschiedlich ausgelenkt werden. Auf diese Weise lassen sich weitere Punktfokussierungen außerhalb des Bereichs der Selektionsblende dadurch vermeiden, daß die Ablenkungen der Ladungsteilchen, die in verschiedenen Schnitten liegen, also die Fundamentalbahnen $x_\alpha$ und $y_\beta$, nicht gleichzeitig einen Nulldurchgang haben (siehe die Fundamentalbahndarstellung bei Kahl, a.a.O., Seite 85). Andererseits müssen jedoch die Ablenkelemente derart ausgestaltet und mit einem derartigen Potential beaufschlagt werden, daß es im gesamten Monochromator ausschließlich in der Ebene der Selektionsblende zu einem stigmatischen Bild der Strahlquelle mit einer Punktfokussierung von Ladungsteilchen einer Energie kommt. Dadurch wird es möglich, die Vorteile der Selektierung der unerwünschten Energien in einem Punktfokus beizubehalten, ohne die starke Vergrößerung der Quellfläche durch weitere Punktfokusse (stigmatische Zwischenbilder) herbeizuführen. Dies ermöglicht große Beleuchtungsströme in Verbindung mit einer geringen Energiebreite der Quelle und führt dadurch zu einer erheblichen Steigerung der Auflösung.

Die Geometrien und Potentiale der Ablenkelemente zur Erzielung der Ablenkbahnen mit einer einzigen Punktfokussierung in der Ebene der Selektionsblende sind auf verschiedenste Weisen möglich. Da es praktisch eine unendliche Vielzahl von Geometrien und Potentialen gibt, die dies bewirken können, muß der Fachmann sich seine gewünschte Lösung aus dieser Vielzahl von Möglichkeiten erarbeiten. Dies geschieht zum einen durch Festlegung auf bestimmte Parameter, die allgemein oder für die konkrete Teilchenoptik, beispielsweise das konkrete Elektronenmikroskop zweckmäßig sind. Dann kann eine Berechnung erfolgen, die die konkrete Form ergibt. Solche Berechnungen sind bekannt, beispielsweise aus der oben genannten Dissertation von Kahl (a.a.O.).

Zunächst ist es natürlich günstig, wenn auch die Anzahl der Strichfokusse minimal gehalten wird, da auch diese einen Boersch-Effekt aufweisen, wenn dieser auch wesentlich geringer ist, als bei einem Punktfokus.

Es könnte also zweckmäßig sein, die Felder so auszugestalten, daß es außer den Nulldurchgängen der Ablenkungen der Ladungsteilchen verschiedener Schnitte in der Ebene der Selektionsblende zu keinen weiteren Fokussen im Monochromator kommt. Auf der anderen Seite ist es aber auch ein Ziel, eine breit auseinandergezogene Dispersion in der Selektionsblende zu erzielen, was bestimmte Bahnkrümmungen erforderlich macht und unter Umständen nur realisierbar ist, wenn man zumindest zwei Strichfokusse in einem Schnitt zuläßt.

Hier müssen also die Vor- und Nachteile für die konkrete Optik abgewogen werden unter der Bedingung, daß die Ablenkelemente so ausgestaltet werden müssen, daß sich die Nulldurchgänge der Amplituden von Ladungsteilchen verschiedener Schnitte ausschließlich im Bereich der Selektionsblende treffen. Eine zweckmäßige Ausgestaltung sieht vor, daß die Ablenkelemente derart ausgebildet sind, daß die Ablenkfelder Umkehrpunkte in der Ablenkung der Ladungsteilchen eines Schnitts (x-Richtung) mit dazwischen liegenden Nulldurchgängen durch die Achse der Ablenkbahn verursachen, jedoch bei Ladungsteilchen eines senkrecht dazu ausgerichteten Schnitts (y-Richtung) lediglich Änderungen der Bahnkrümmungen mit einem einzigen Nulldurchgang durch die optische Achse im Bereich der Selektionsblende auftritt. Treten Nulldurchgänge nur in der x- oder y-Richtung auf, so kommt es lediglich zu Strichfokussierungen, die einen wesentlich geringeren Boersch-Effekt aufweisen.

Daß hier die Ladungsteilchen der Schnitte in x- und y-Richtung, also die Fundamentalbahnen $x_\alpha$ und $y_\beta$, angegeben sind, dient natürlich nur der Beschreibung der Verformung des Strahlenbündels durch die elektrischen Felder. Tatsächlich ist der gesamte Strahlenquerschnitt der x-y-Ebene mit Ladungsteilchen gefüllt und alle nehmen an Verformungen des Strahlenquerschnitts teil, so daß der gesamte Strahl auch mit den Ladungsteilchen, bei denen $\alpha$ und $\beta$ zwischen Null und einem Maximalwert liegen, im Strichfokus zu einem Strich in x- oder y-Richtung und im Punktfokus zu einem Punkt gebündelt wird. Der Teilchenstrom bildet also außer in der Selektionsblende (Punktfokus) wechselweise Striche - soweit Strichfokusse zugelassen sind - die sich in x- oder y-Richtung erstrecken und dazwischen bildet er Ellipsen, die ihrer Länge nach abwechselnd in der einen oder anderen Richtung liegen, und als Übergang dazwischen Kreise. Die Strichfokusse sind dann Nulldurchgänge für die Ladungsteilchen des x- oder y-Schnitts und im Punktfokus sind Nulldurchgänge für alle Schnitte.

Der erfindungsgemäße Monochromator hat seine Vorzüge sowohl für Rasterelektronenmikroskope als auch für Ruhbildelektronenmikroskope. Es kann die Rasterfunktion verbessert werden, da durch die Monochromasie ein kleinerer Spot (Bildpunkt) erzielbar ist. Für die Ruhbildabbildung können die Intensitätskontraste der einen Linienfokus begrenzenden Schlitzblende (siehe oben, Würdigung der DE 196 33 496 B4) mit einer Streifenstruktur der Lichtintensität des Bildes vermieden werden. Die Erfindung ist daher besonders für Elektronenmikroskope geeignet, die sowohl über eine Rasterbildgebung als auch über eine Ruhbildgebung verfügen.

Um die Ablenkfelder zu erzeugen, sind Ablenkelemente mit in ein oder zwei Dimensionen gekrümmte Flächen vorgesehen. Diese schließen bogenförmige Bahnen ein, die, wenn die Ladungsteilchen Elektronen oder negativ geladene Ionen sind, an der Innenseite eine positive und an der Außenseite eine negative Spannung gegenüber dem Achspotential aufweisen, um die Ladungsteilchen auf dieser Bahn zu führen. Um Ladungsteilchen verschiedener Schnitte unterschiedlich zu beeinflussen, müssen Felder erzeugt werden, die vom Kugelfeld unterschiedlich sind. Dazu dienen Elektroden mit Ablenkfeldern die bezüglich der Ablenkbahn asymmetrisch sind, also in x- und in y-Richtung verschiedene Stärken aufweisen. Dabei sind die Verhältnisse bezüglich der x-Ebene, in der die gekrümmte optische Achse verläuft, bezüglich Geometrie und Potentialverläufen symmetrisch, so daß die Bahn in dieser Symmetrieebene bleibt.

Der Weg des Fachmanns zum Auffinden einer bestimmten Lösung kann beispielsweise in der Art erfolgen, wie dies bei Kahl (a.a.O.) beschrieben ist, jedoch selbstverständlich unter der Vorgabe, daß ein stigmatisches Zwischenbild der Quelle (Punktfokus) in der Selektionsblende liegen muß. Es müssen also die Berechnungsgrundlagen insofern abgeändert werden.

Der prinzipielle Weg des Fachmanns wird jedoch hier unter Verweis auf Kahl (a.a.O.) kurz skizziert. Zunächst muß der Fachmann die Form der Achse E des Monochromators wählen. Er entscheidet sich beispielsweise für die $\Omega$-Form, um eine - abgesehen von der Unterbrechung durch den Monochromator - gerade optische Achse der Ladungstteilchenoptik, beispielsweise des Elektronenmikroskops, zu erzielen. Bildet er das $\Omega$ relativ steil aus, so daß Ein- und Ausgang nahe zusammenrücken, erhält er eine geringe Bauhöhe, was ebenfalls erstrebenswert ist. Der Fachmann wird gleiche Spannungen für die Elektroden der Ablenkelemente wählen, da dies die Betriebsstabilität erhöht, weil die Spannungen der Ablenkelemente nicht gegeneinander schwanken können. Weiterhin wird er eine möglichst große Dispersion im Punktfokus wählen, damit die Selektion der gewünschten Energie exakt vorgenommen werden kann.

Der erste Schritt wird dann sein, unter diesen Prämissen die Krümmungen der optischen Achse, beispielsweise die $\alpha$- oder aus den oben genannten Gründen die $\Omega$-Form auszuwählen. Dabei wird die Krümmung der Achse allein durch die elektrischen Dipole der Elektroden der Ablenkelemente bestimmt. Zur Berechnung der Fundamentalbahnen der Ladungsteilchen dient ein orthogonales Koordinatensystem mit einer z-Achse, die der Achse E des Monochromators entspricht, also krummlinig ist. In dieses Koordinatensystem werden die Ablenkelemente eingefügt, die als Abschnitte von Toroiden ausgebildet sind, damit diese Formen einer Näherungsrechnung zugrundegelegt werden können. Es handelt sich um eine Berechnung nach der SCOFF-Nährung (Sharp-Cut-Off Fringe Field-Nährung) zur Berechnung der konkreten Geometrie, wie bei Kahl (a.a.O.) Kapitel 5, Seite 57 ff. offenbart. Dabei wird eine Fundamentalbahnberechnung (a.a.O., 4.4.2, S. 44 ff.) zugrundegelegt, die die hier gestellten Bedingungen an die Fokusse enthält. Die konkreten Ausgestaltungen der Flächen der Elektroden verlaufen in dem orthogonalen Koordinatensystem symmetrisch zum xz-Schnitt. Auf jeden Fall weisen die Flächen der Toroide für jeden Ort auf der z-Achse dieselben Abstände auf, so daß das Toroid für die Berechnung der SCOFF-Näherung als geometrische Figur zur Verfügung steht. Unter Toroid wird hier eine Kreisringform jeglichen Querschnitts der beanspruchten Art verstanden. Vorzugsweise bilden die Flächen, zwischen denen die Ablenkbahn verläuft, keine Zylinderflächen in y-Richtung. Dadurch können den Dipolen Multipole überlagert werden, da das jeweilige Potential erhöht wird, wenn die Elektrode an einer Stelle in der x-y-Ebene geometrisch näher an die optische Achse herankommt, und umgekehrt erniedrigt wird, wenn sie weiter entfernt ist. Der Zweck besteht darin, daß durch diese Ausgestaltung der Ablenkfelder den durch den Monochromator verursachten Öffnungsfehlern entgegengewirkt werden kann. Bei den Multipolen kann es sich um Quadrupole, Hexapole oder höherzahlige Multipole handeln, wobei die letzteren dazu dienen, auch Öffnungsfehler dritter oder höherer Ordnung zu minimieren. Bezüglich der Berechnung der Elektrodenform wird auf Kahl (a.a.O., 5.3, S. 61 ff; 8.5, S. 94 ff und S. 125, 126) verwiesen.

Die Berechnung der konkreten Form, einschließlich der Berücksichtigung der Randbereiche der toroidförmig durch die Elektroden begrenzten Ablenkbahnen für den Aufbau der Ablenkfelder findet durch Triangulierung (a.a.O., 9.1, S. 99 ff) und ein Iterationsverfahren statt (Kahl, a.a.O., 9.3.9.4 und 9.5, S. 108ff).

Die folgende Tabelle gibt eine bevorzugte Parameterwahl für ein System an, bei dem die Dipolfelder durch Quadrupolfelder überlagert sind:

| Parameter | Einheit | bevorzugte Wahl |
|---|---|---|
| Ablenkwinkel jedes Ablenkers (0) | deg | 120...150 |
| $R_2/R$ | 1 | 1.4...1.8 |
| Quadrupol im 1. Ablenker $\Phi_2 \cdot \dfrac{R^2}{U}$ | 1 | 0.08...0.3 |
| Quadrupol im 2. Ablenker $\Phi_2 \cdot \dfrac{R^2}{U}$ | 1 | 0.2...0.4 |
| Abstand zwischen 1. und 2. Ablenker | R | 0.05...0.4 |
| Abstand 2. Ablenker zur Selektionsblende | R | 0.05...0.5 |
| Lage des virtuellen Bildes hinter Eintritt | R | 1.5...2.5 |
| Virtueller Abstand der Blende vom Eintritt | R | 2...20 |

Dabei ist:

$$R_1 = R = \frac{2U}{\Phi_1}$$ der Krümmungsradius des ersten Ablenkelements

R gibt an, daß die Längen in Einheiten des Krümmungsradiusses des 1. Ablenkelements gemessen werden.
$R_2$ der Krümmungsradius des 2. Ablenkers
$\Phi_1$ die Feldstärke des Dipolfeldes
$\Phi_2$ die Feldstärke des Quadrupolfeldes
U die Potentialdifferenz zwischen Kathode und der Achse - vorzugsweise im ganzen Monochromator konstant.

Durch die Wahl der Stärke der Feldkomponenten $\Phi_1$ (Dipol) und $\Phi_2$ (Quadrupol), der Bogenradien und Bogenwinkel der Ablenkelemente und damit der Bogenlänge der Ablenkelemente und der feldfreien Zwischenräume lassen sich die Bahnen gezielt beeinflussen. Insgesamt ergibt sich eine Anzahl von Freiheitsgraden des Monochromators, denen Forderungen gegenüberstehen, etwa wo Fokusse entstehen sollen und daß das System am Ende dispersionsfrei wird. Wählt man etwa die Dipolund Qadrupolstärken in einem Ablenker ungefähr konstant, so ergeben sich etwa die Freiheitsgrade der o.g. Tabelle. Aus den Feldkomponenten $\Phi_1$ und $\Phi_2$ (und eventuell gewählten weiteren) ergeben sich die Elektrodenoberflächen der Ablenkelemente durch Aufsuchen der Flächen φ = const. Entsprechend Gleichung (5.4), S. 61 Diss. Kahl (a.a.O.) auf beiden Seiten der Achse für φ+ > U und φ- < U. Diese elektrostatischen Potentiale φ+ und φ- müssen dann an die metallischen Ablenkelemente gebracht werden.

Bei einem Hexapol zur Kompensation eines Öffnungsfehlers zweiter Ordnung muß eine weitere Feldkomponente $\Phi_3$ in die Berechnung einbezogen werden.

Die nach der o.g. Methode aufgefundenen Flächen der Elektroden können unterschiedlich geformte Flächen sein. Voraussetzung ist lediglich, daß es keine Kugelflächen sind, da mit diesen immer mehrere Punktfokussierungen entstehen. Bei Flächen, die von einer Kugelsymmetrie weit genug entfernt sind, treten Strichfokussierungen auf. Vorzugsweise sind die Flächen in y-Richtung gekrümmt, aber zur xz-Ebene spiegelsymmetrisch. Zweckmäßigerweise werden dabei die Elektroden der Ablenkelemente derart geformt, daß sie die Ablenkbahnen durch Flächen begrenzen, die Ausschnitte aus einer Kegelstumpfmantelfläche sind. Dabei können diese Flächen zwei "V" bilden, die mit den Spitzen in die gleiche Richtung weisen. Dazwischen verläuft dann die Ablenkbahn. Eine weitere Möglichkeit besteht darin, daß die Flächen, die zwei "V" bilden, die mit den Öffnungen zueinander weisen. Dann umschließen sie die in ihrer Mitte liegende Ablenkbahn. Neben der Erzielung der gewünschten Funktion, daß - mit Ausnahme des Bereichs der Selektionsblende - nur Strichfokussierungen entstehen, haben die vorgenannten Ablenkelemente den Vorteil, daß sie leicht herstellbar sind, da die Flächen durch Rotation gerader Linien um eine Achse gebildet werden. Solche Flächen sind ohne weiteres durch eine Rotation um die Achse der Kegelstümpfe mittels Drehautomaten, Rundschleifmaschinen und ähnlichem durch einen geradlinigen Werkzeugvorschub herstellbar, und das Arbeitsergebnis läßt sich auch auf einfache Weise durch Meßtaster oder optische Flächenerfassung überprüfen. Entsprechendes gilt für die äußeren Elektroden, die dann Flächen bilden, die von außen einen gedachten Kegelstumpf begrenzen und in entsprechender Weise mit einem Werkzeug von innen bearbeitet werden, z. B. als aufgespannte Napfform, aus der nach Beendigung der Dreh- und eventueller Schleifarbeiten die jeweilige Elektrode ausgeschnitten wird.

Vorzugsweise ist der Monochromator um eine Ebene symmetrisch aufgebaut, wobei die Symmetrieebene der Ebene der Selektionsblende entspricht. Dabei führt auch eine spiegelbildliche Anordnung der Ablenkelemente dazu, daß auf die Ladungsteilchen nach der Selektionsblende die gleichen Kräfte wirken wie vor der Selektionsblende, nur entgegengesetzt gerichtet. Auf diese Weise wird die Dispersion der Ladungsteilchen des selektierten Strahls nach der Herbeiführung der Dispersion durch das oder die ersten Ablenkelemente wieder vollständig beseitigt.

Der Monochromator kann - wie oben schon angesprochen - bezüglich seiner optischen Achse eine Vielzahl von Formen aufweisen, die Ausführungsbeispiele der Zeichnung geben dies beispielhaft an. Sie kann im Wesentlichen die Form einer Schlaufe haben, wobei bei dieser Ausgestaltung die Achsen bei einem Schließen der Schlaufe nicht völlig ineinander laufen dürfen, da sonst der Weg der Teilchen nicht mehr eindeutig bestimmt ist. Daher muß es sich entweder um eine offene Schlaufe oder eine Schlaufe mit seitlichem Versatz der Eingangs- zur Ausgangsachse handeln oder die Eingangsund die Ausgangsachse müssen sich überkreuzen. Denkbar wäre natürlich auch, daß ein Ineinanderlaufen dadurch vermieden wird, daß die optische Achse nicht ganz exakt in der x-Ebene bleibt (abweichend zur o.g. Symmetrieebene, in der die optische Achse liegen soll).

Besonders zweckmäßig ist jedoch ein Monochromator, bei dem die optische Achse am Ausgang des Monochromators mit der optischen Achse am Eingang des Monochromators - das ist in der Regel die Verlängerung der optischen Achse der Strahlquelle - übereinstimmt. Dies ist erzielbar, wenn die optische Achse des Monochromators im Wesentlichen die Form eines $\Omega$ aufweist, wobei die Bogenelemente des $\Omega$ sowohl als starke Bögen wie auch als kurze und flache Bögen ausgebildet sein können. Dabei wird die $\Omega$-Form durch zwei bogenförmige Ablenkelemente vor der Selektionsblende und zwei bogenförmige Ablenkelemente nach der Selektionsblende gebildet. Die kreisbogenförmigen Ablenkbahnen der Ablenkelemente weisen dabei vorzugsweise einen Bogenwinkel zwischen 120° und 150° auf, wie dies bereits die obige Tabelle angibt.

Ein besonderer Vorzug dieser $\Omega$-Form besteht darin, daß es möglich ist, daß das Eingangs- und das Ausgangsablenkelement mit einem Strahldurchtritt auszustatten, so daß beim Ausschalten des Monochromators die Ladungsteilchen geradlinig die Strahldurchtritte passieren können und sich damit entlang der optischen Achse zum Ausgang des Monochromators bewegen. Auf diese Weise kann die Bildgebung mit oder ohne Monochromator erfolgen. Dabei ist es besonders zweckmäßig, wenn der virtuelle Eingangs-Crossover und der virtuelle Ausgangs-Crossover des Monochromators in dessen Symmetrieebene zusammenfallen. Dadurch bleibt der Strahlengang auch beim Ausschalten des Monochromators erhalten. Auf diese Weise kann er ein- und ausgeschaltet werden, ohne daß jeweils eine neue Justierung des Strahlengangs vorgenommen werden muß.

Eine Weiterbildung sieht vor, daß die Elektroden außen mit parallel zur optischen Achse ausgerichteten Platten auf Nullpotential abgeschirmt sind. Weiterhin können senkrecht zur optischen Achse beidseitig der Ablenkelemente, also am Ein- und Ausgang, Abschirmplatten auf Extraktorpotential angebracht sein, die eine kleine Bohrung als Durchtrittsöffnungen für den Strahldurchtritt enthalten. Dadurch wird das Ablenkfeld definiert begrenzt und ist unabhängig von weiteren potentialführenden Teilen in der Umgebung des Aufbaus. Dies dient einer Beherrschbarkeit und Berechenbarkeit der Randfelder der toroidförmigen Ablenkelemente. Es kann auch vorgesehen sein, daß die Elektroden kastenförmige Abschirmungen auf Extraktorpotential mit Durchtrittsöffnungen für den Ladungsteilchenstrom aufweisen.

Ein weiterer Gegenstand der Erfindung ist eine Strahlquelle mit einem Monochromator der vorgenannten Art, wobei dem Monochromator eine als Extraktor ausgebildete Strahlquelle mit einer elektrostatischen Linse und einer kreisförmigen Blende zur Regulierung und Begrenzung des Teilchenstroms vorgeordnet ist, wobei die Linse ein virtuelles Bild der Strahlquelle bildet, da dieses hinter dem Eingang des Monochromators liegt. Auf diese Weise läßt sich die dem Monochromator zugeführte Ladungsteilchenausbeute verbessern.

Nachfolgend wird die Erfindung anhand der Zeichnung erläutert. Es zeigen:

Fig. 1      eine Prinzipskizze einer einfach aufgebauten Ausführungsform der Erfindung,

Fig. 2      eine bevorzugte Ausführungsform,

Fig. 3      ein Ladungsteilchenstrahl am Eingang des Monochromators,

Fig. 4a     ein Beispiel eines Verlaufs der Ablenkbahn eines Monochromators,

Fig. 4b     die Ablenkfelder und die Auslenkungen der Ladungsteilchen $x_\alpha$ und $y_\beta$ gegenüber der Achse,

Fig. 5a, 5b     ein weiteres Beispiel,

Fig. 6a, 6b     dasselbe für die Ausführungsform gem. Fig. 2,

Fig. 7          ein Schnitt durch die Selektionsblende mit beispielhaften Fokussen verschiedener Energiebereiche,

Fig. 7a         die Selektionsblende in Draufsicht,

Fig. 8          eine Schlitzblende des Standes der Technik,

Fig. 8a         die Intensitätsverteilung der Stromdichte über das Bild und

Fig. 8b         streifenförmige Intensitätsunterschiede im Bild beim Einsatz einer Schlitzblende,

Fig. 9          eine Ausführungsform eines Ablenkelements der Erfindung und

Fig. 9a         eine weitere Ausführungsform,

Fig. 10a        eine Prinzipskizze des Querschnitts eines Ablenkelements mit Bildung eines Hexapols und

Fig. 10b        mit Bildung eines Quadrupols.

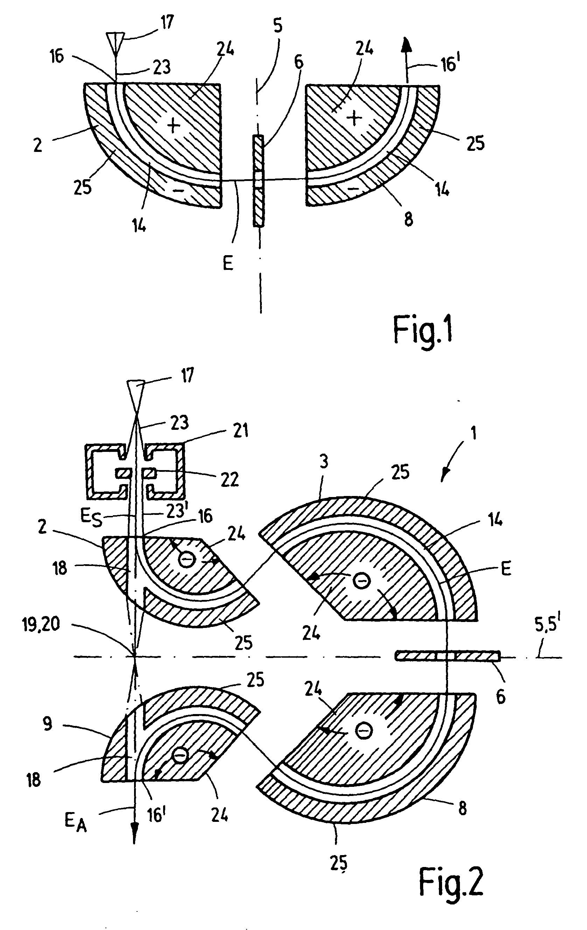

**Fig. 1** zeigt eine Prinzipskizze einer einfach aufgebauten Ausführungsform eines Monochromators 1 gemäß der Erfindung. Der Teilchenstrom 23 einer Strahlquelle 17 trifft dabei auf den Eingang 16 des Monochromators 1 und wird durch das Ablenkfeld 2' eines ersten Ablenkelements 2 umgelenkt um eine Dispersion 4 (siehe unten) zu erzeugen. Dieser Umlenkung dient eine innere Elektrode 24 und eine äußere Elektrode 25, welche eine bogenförmige Ablenkbahn 14 begrenzen. Besteht der Teilchenstrom 23 aus Elektronen oder negativ geladenen Ionen, so ist die innere Elektrode 24 positiv und die äußere Elektrode 25 negativ geladen. Wenn der Teilchenstrom 23 entlang der optischen Achse E des Monochromators 1 umgelenkt dispers auf die in der Ebene 5 liegende Selektionsblende 6 trifft, wird dort nur der gewünschte Energieintervall 7 durchgelassen. Dies wird weiter unten noch ausführlich erläutert. Um die Dispersion 4 wieder aufzuheben, ist ein weiteres Ablenkelement 8 vorgesehen, dessen Ablenkfeld 8' die dispersen Strahlen wieder zusammenführt und auf diese Weise am Ausgang 16' des Monochromators 1 einen Teilchenstrom höherer Monochromasie zur Verfügung stellt.

Bei allen Darstellungen zeigen gleiche Bezugszeichen funktionsidentische Bauelemente oder Kurvenverläufe. Die jeweils getroffenen

**Fig. 2** zeigt eine bevorzugte Ausführungsform der Erfindung. Hier ist sowohl ein Monochromator 1 dargestellt, als auch eine Strahlquelle 17, die zur Regulierung und Begrenzung des Teilchenstroms 23 mit einer elektrostatischen Linse 21 und einer Blende 22 ausgestattet ist. Die Strahlquelle 17 ist ein ZrO/W Schottky-Emitter mit Wolframfadenheizung, Suppressor und einer als kreisrunde Blende ausgebildeten Anode, dem Extraktor. Das Potential des Extraktors ist in der Regel das Nullpotential (Achspotential), das hier für den Monochromator beschrieben ist.

Der durch die Linse 21 und die Blende 22 regulierte und begrenzte Teilchenstrom 23' trifft auf den Eingang 16 des Monochromators 1. Dieser Monochromator 1 verfügt über vier Ablenkelemente, wobei zwei Ablenkelemente 2, 3 vor der Selektionsblende 6 und zwei weitere Ablenkelemente 8, 9 nach der Selektionsblende 6 angeordnet sind. Dabei ist dieser Monchromator 1 derart aufgebaut, daß die optische Achse E die Form eines $\Omega$ beschreibt. Die bogenförmigen Bahnen beschreiben Bögen im Bereich zwischen 120° und 150°, da die Ablenkelemente 2, 3, 8, 9 entsprechende Winkel $\theta$ aufweisen. Die Ebene 5 der Selektionsblende 6 ist dabei die Symmetrieebene 5' des Monochromators 1.

Um beim Ausschalten des Monochromators 1 ebenfalls noch eine Bildgebung erzielen zu können, ist der Monochromator 1 so aufgebaut, daß die optische Achse Es am Eingang 16 des Monochromators 1 exakt in die gleiche Richtung verläuft wie die optische Achse $E_A$ am Ausgang 16' des Monochromators 1. Entlang dieser Verbindungslinie sind das Ablenkelement 2 und das Ablenkelement 8 mit Strahldurchtritten 18 ausgestattet, so daß nach einem Abschalten des Monochromators 1 der Strahl unter Umgehung des Monochromators 1 direkt vom Eingang 16 zum Ausgang 16' weitergeleitet wird.

Dabei wird zweckmäßigerweise der Strahlengang derart ausgestaltet, daß der virtuelle Eingangs-Crossover 19 und der virtuelle Ausgangs-Crossover 20 des Monochromators 1 in dessen Symmetrieebene 5' zusammenfallen. Auf diese Weise wird der gleiche Verlauf des Strahlengangs erzielt, unabhängig davon, ob der Monochromator 1 ein- oder ausgeschaltet ist. Der einzige Unterschied besteht natürlich darin, daß bei ausgeschaltetem Monochromator 1 nicht dieselbe Monochromasie erzielt wird. Durch diese Ausgestaltung bleibt somit beim Ausschalten des Monochromators 1 das Bild vollständig erhalten und am selben Ort, lediglich mit geringerer Auflösung durch den Wegfall der Funktion des Monochromators 1.

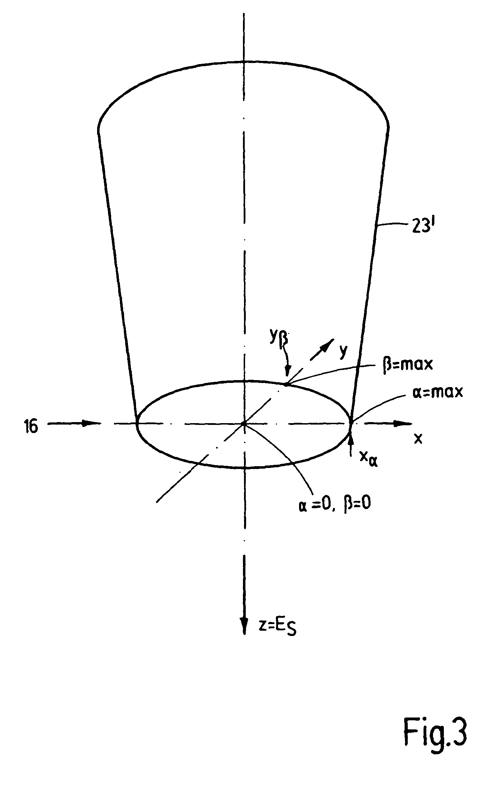

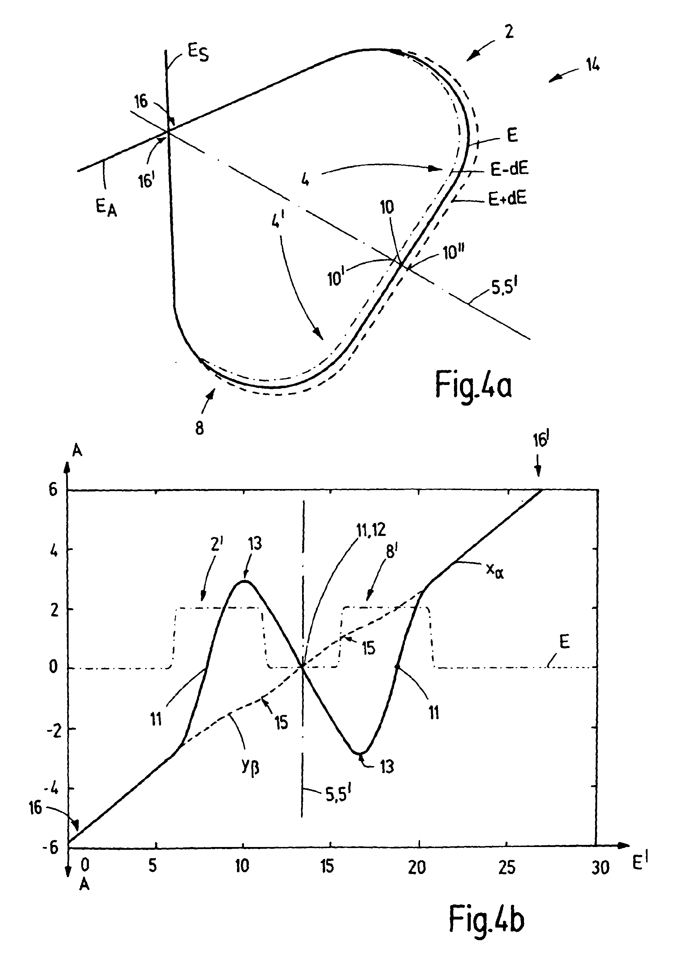

**Fig. 3** zeigt einen Ladungsteilchenstrahl 23' am Eingang 16 des Monochromators 1. Diese Darstellung dient dazu, die in den folgenden Darstellungen verwendeten Zeichen sowie die zugrungeliegenden Zusammenhänge klarzustellen. Der Teilchenstrom 23' besteht am Eingang 16 des Monochromators 1 aus einer Vielzahl von Ladungsteilchen, welche nicht exakt der optischen Achse Es am Eingang 16 des Monochromators 1 folgen, sondern davon gewisse Abweichungen aufweisen. Diese optische Achse Es entspricht in der Regel der optischen Achse der Strahlungsquelle 17. Die von dieser Strahlungsquelle 17 ausgehenden Ladungsteilchen weisen außer der theoretischen Möglichkeit eines genauen Verlaufs in der Achse Es gewisse Winkelabweichungen zur Achse Es auf. Diese Winkelabweichungen werden mittels eines Raumkoordinatensystems x, y, z erfaßt, wobei z dem Verlauf der optischen Achse Es entspricht. Die Winkelabweichungen werden als Winkel $\alpha$ oder als Winkel $\beta$ angegeben, dies sind die Winkel, unter denen die Ladungsteilchen virtuell in das Bild der Quelle (Crossover 19 in Fig. 2) einlaufen. Dabei werden statt der Winkel die Koordinaten x und y am Eingang 16 des Monochromators 1 erfaßt und in den folgenden Darstellungen die Auslenkungen A der Ladungsteilen $x_\alpha$ und $y_\beta$ zur optischen Achse E des Monochromators 1 dargestellt. Die Ladungsteilchen bewegen sich dabei auf einem krummlinigen - entsprechend des Aufbaus des Monochromators 1, beispielsweise in $\Omega$-Form - orthogonalen Koordinatensystem, wobei die Achse des Systems mit der Bahn eines Referenzladungsteilchens der Sollenergie und den Winkeln $\alpha$=0 und $\beta$=0 übereinstimmt. Dabei ist dann E' der jeweilige Ort auf der optischen Achse E, welche in den Diagrammen 4b, 5b und 6b der Abszisse entspricht, auf der Ordinate ist die Auslenkung der Ladungsteilchen zur optischen Achse E aufgetragen. Für ein Teilchen, das sich genau auf der optischen Achse E befindet, für das also ein Winkel $\alpha$ von 0 und ein Winkel $\beta$ von 0 gilt, wäre die Bahn durch den Monochromator 1 exakt entlang von dessen optischer Achse E. Alle anderen Ladungsteilchen vollziehen Bahnen mit unterschiedlichen Auslenkungen A von der optischen Achse E in Abhängigkeit vom jeweiligen Ort E' auf der optischen Achse E. Da nicht alle Ladungsteilchen darstellbar sind, werden für die Darstellungen in den Figuren 4b, 5b und 6b zwei herausgegriffen, das Ladungsteilchen $x_\alpha$ mit dem maximalen Winkel $\alpha$, das sich also auf der x-Achse am Rand des Teilchenstroms 23' befindet. Dessen Auslenkung $\beta$ ist 0. In entsprechender Weise wird die Bahn des Teilchens $y_\beta$ aufgezeigt, das bei maximalem Winkel $\beta$ einen Winkel $\alpha$ von 0 aufweist.

Die **Fig. 4a** zeigt ein Beispiel eines Verlaufs einer Ablenkbahn 14 eines Monochromators 1, der eine schlaufenförmige Ablenkbahn 14 aufweist. Monochromatoren 1 verfügen über bogenförmige Ablenkbahnen 14, um die Ladungsteilchen verschiedener Energien voneinander zu trennen. Bei solchen bogenförmigen Ablenkbahnen 14 werden schnellere Ladungsteilchen mit höherer Energie nach außen getragen und haben eine Achsabweichung dE - die proportional zur Energieabweichung ist - von der Achse E, wie dies für die stärkste Abweichung mit der gestrichelten Linie E + dE eingetragen ist. Das Umgekehrte tritt bei Ladungsteilchen geringer Energie auf, sie folgen der strichpunktierten Linie E-dE. Die Achsabweichung ist proportional zur Energiedifferenz zur Sollenergie. Kommt es im Bereich einer derartigen Dispersion 4 zu Zwischenbildern als Punkfokussierungen, so werden diese entsprechend der Dispersion auseinandergezogen, so daß eine Punktfokussierung 10 ebenfalls einen Strich bildet, der vom Punktfokus 10' der geringsten Energie bis zum Punktfokus 10" der stärksten Energie reicht. Diese Tatsache nützt der Monochromator 1 aus, um nur einen gewünschten Energieintervall 7 durchzulassen. Dies wird zu Fig. 7 noch näher erläutert, wobei die Fig. 8 zeigt, wie der bezüglich des Standes der Technik oben beschriebene Strichfokus aussieht, wenn dieser gleichzeitig mit einer Dispersion 4 auftritt.

Bei der Darstellung der **Fig. 4a** sind lediglich zwei Ablenkelemente 2 und 8 eingesetzt, wobei sich in der dazwischenliegenden Symmetrieebene 5' des Monochromators 1 die Selektionsblende 6 befindet. Die Ebene 5 der Selektionsblende 6 ist hier mit der Symmetrieebene 5' identisch.

Im Gegensatz zum Verlauf der Dispersion 4 und deren Eliminierung 4' zeigt **Fig. 4b** die Auslenkung A der Ladungsteilchen $x_\alpha$ und $y_\alpha$ zur optischen Achse E, also die Fundamentalbahnen $x_\alpha$ und $y_\beta$, wobei die Ordinate für die Ladungsteilchen $x_\alpha$ die Auslenkung A in x-Richtung des Raumkoordinatensystems zeigt und für die Ladungsteilchen $y_\beta$ die Auslenkung A in y-Richtung. Auf der Abszisse ist der jeweilige Ort E' auf der optischen Achse E zwischen dem Eingang 16 des Monochromators 1 und dessen Ausgang 16'aufgetragen. Man muß sich dies so vorstellen, daß sich die in Fig. 4a gezeigte Dispersion 4 und die unterschiedlichen Auslenkungen A der Teilchen $x_\alpha$, $y_\beta$ (für alle Winkel $\alpha$ und $\beta$ zwischen Maximum und Minimum) wie in Fig. 4b dargestellt überlagern.

Die Darstellung zeigt zunächst die den Ablenkelementen 2 und 8 der Fig. 4a entsprechenden Ablenkfelder 2' und 8'. Da diese Ablenkfelder 2' und 8' bezüglich der optischen Achse E in x- und y-Richtung asymmetrische Felder 2', 8' aufweisen - hier ist nur die Stärke der Dipolkomponente $\Phi_I$ erkennbar -, werden die $x_\alpha$-Teilchen wesentlich anders ausgelenkt wie die $y_\beta$-Teilchen. Hier werden die $x_\alpha$-Teilchen durch das erste Ablenkfeld 2' durch einen Nulldurchgang 11 geführt, so daß dort ein Strichfokus bzw. eine strichförmige Abbildung der Strahlungsquelle 17 entsteht. Der Verlauf dieser Teilchen $x_\alpha$ geht dann durch einen Umkehrpunkt 13 und verläuft derart, daß ein weiterer Nulldurchgang 11 genau in der Ebene 5 der Selektionsblende 6 auftritt. Im Gegensatz dazu werden die $y_\beta$-Teilchen von dem Ablenkfeld 2' nur sehr wenig beeinflußt, so daß es dort lediglich zu einer Änderung 15 der Bahnkrümmung kommt. Da die $y_\beta$-Teilchen durch das Ablenkfeld 2' so geführt werden, daß sie ebenfalls in der Ebene 5 der Selektionsblende 6 einen Nulldurchgang 12 aufweisen, kommt es in dieser Ebene 5 der Selektionsblende 6 zu einem Punktfokus, ohne daß es einer anderen Stelle des Monochromators 1 zu einem weiteren Punktfokus kommt. Dieser Punktfokus ist allerdings durch die Dispersion 4 in oben genannter Weise ein Strich, so daß die Selektion des gewünschten Energieintervalls 7 durchgeführt werden kann (siehe Fig. 7). Nachfolgend wirkt das Ablenkfeld 8' genau entgegengesetzt, so daß die Teilchen $y_\beta$ und $x_\alpha$ wieder gegenüber dem Eingang 16 des Monochromators 1 mit gleicher Bahnhöhe und Steigung in ihrem jeweiligen Schnitt den Monochromator 1 verlassen. Dabei kommt es zusätzlich zu einer Eliminierung 4' der Dispersion 4, wie dies auch der Fig. 4a dadurch entnehmbar ist, daß die Kurven E-dE, E und E+dE vor dem Ausgang 16' des Monochromators 1 wieder vereinigt sind.

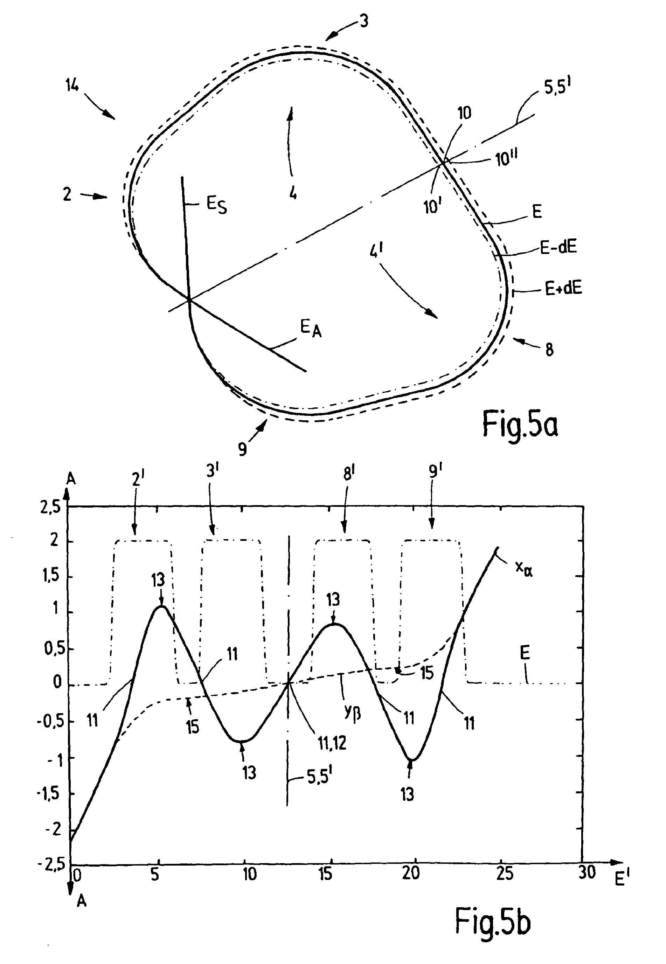

Die **Fig. 5a und 5b** zeigen ein weiteres Beispiel, das dem eben beschriebenen entspricht, wobei jedoch der Unterschied darin besteht, daß die Schlaufe der Ablenkbahn 14 aus vier Ablenkelementen 2, 3, 8, 9 der Fig. 5a besteht.

In entsprechender Weise zeigt die **Fig. 5b** einen Fundamentalbahnverlauf der Teilchen $x_a$ und $y_\beta$ der im Unterschied zum oben ausgeführten durch vier Ablenkfelder 2', 3', 8' und 9' bewirkt wird, wobei diese Ablenkfelder 2', 3', 8', 9' den vier Ablenkelementen 2, 3, 8, 9 entsprechen. Ansonsten gilt das oben Beschriebene in entsprechender Weise.

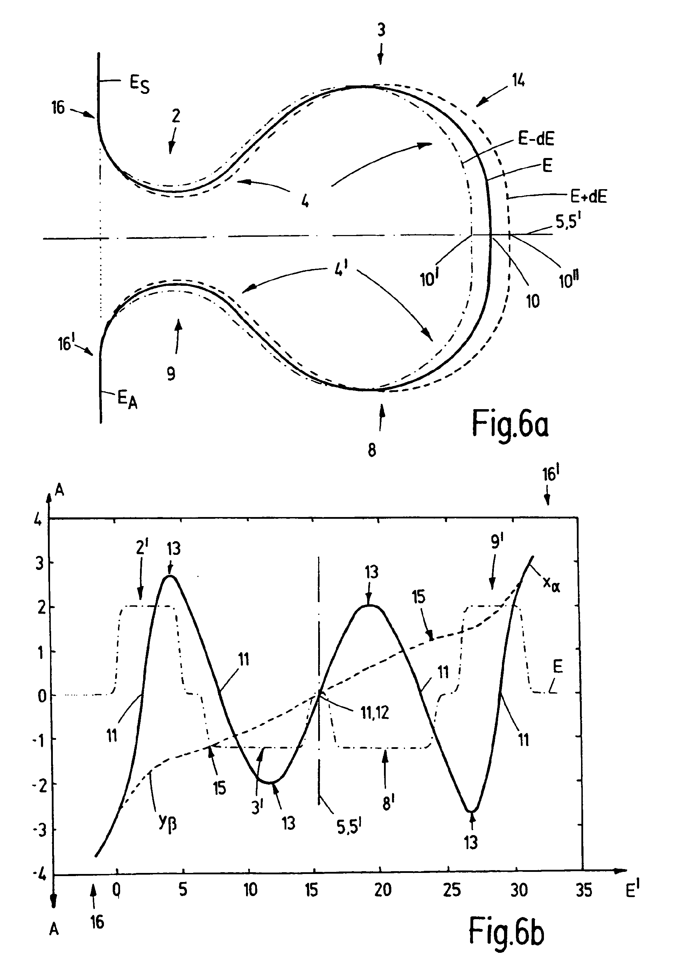

Die **Fig. 6a und 6b** zeigen den Verlauf der Ablenkbahn 14, die Ablenkfelder 2', 3', 8', 9' und die Auslenkungen A für einen Monochromator 1, dessen Ablenkbahn 14 die Form eines $\Omega$ aufweist. Die Prinzipien gelten wie oben beschrieben, mit dem Unterschied, daß die Ablenkelemente 2 und 3 entgegengerichtet wirkende Ablenkfelder 2' und 3' haben, so daß es in diesem Bahnbereich - wie in Fig. 6a zu sehen - zwischendurch zu einer Zusammenführung der Dispersion 4 verschiedener Energien kommt. Jedoch tritt in der Ebene 5 - wie oben beschrieben - eine Dispersion 4 auf, welche ebenfalls dazu führt, daß es dort zu Punktfokussen 10, 10' und 10'' verschiedener Energien kommt und dadurch ein gewünschter Energieintervall 7 selektiert werden kann. Auch hier sorgen dann die Ablenkelemente 8 und 9 mit ihren Ablenkfeldern 8' und 9' dafür, daß eine Eliminierung 4' der Dispersion 4 eintritt, wie dies **Fig. 6a** dadurch zeigt, daß am Ausgang 16' des Monochromators 1 die Kurven für E-dE und E+dE wieder mit der Kurve E vereinigt sind.

Diese verschieden gerichteten Ablenkfelder 2', 3', 8' und 9' sind auch in **Fig. 6b** zu sehen und der aus den Wirkungen dieser Felder resultierende Verlauf der Auslenkungen A der Ladungsteilchen $x_\alpha$ und $y_\beta$, also des Fundamentalbahnverlaufs. Auch hier haben beide Ladungsteilchen $x_\alpha$ und $y_\beta$ in der Ebene 5 der Selektionsblende 6 ihre Nulldurchgänge 11 und 12. Es kommt also auch hier nur an dieser Stelle zu den Punktfokussen 10, 10' und 10''. Zur Verdeutlichung wird natürlich nochmals darauf hingewiesen, daß bei dieser Darstellung wie bei den obigen die Teilchen $x_\alpha$ und $y_\alpha$ nur exemplarisch herausgegriffen sind, da sie die beiden Extreme $\alpha$ = max. und $\beta$ = 0 beziehungsweise $\beta$ = max. und $\alpha$ = 0 darstellen. Alle anderen Teilchen bewegen sich in einem Raum zwischen diesen beiden Extremen. Somit tritt beim Zusammentreffen der Nulldurchgänge 11 und 12 ein Punktfokus aller Ladungsteilchen auf, bei den anderen Nulldurchgängen 11 Strichfokusse und dort, wo sich die Linien von $x_\alpha$ und $y_\beta$ kreuzen runde Querschnitte des Ladungsteilchenstroms. Dazwischen bilden sich elliptische Querschnitte, deren Längsachsen abwechslungsweise in x- und in y-Richtung ausgerichtet sind. Bei dem einzigen Punktfokuß 11, 12 der Teilchen $x_\alpha$, $y_\beta$ in der Selektionsblende 6 handelt es sich um Punktfokusse 10, 10', 10'' (siehe Fig. 4a, 5a, 6a, 7 und 7a) für verschiedene Energien der Ladungsteilchen, wobei die Punktfokusse 10' und 10'' für die geringste und die stärkste Energie natürlich nur die Begrenzungen für die Fokusse aller dazwischen liegender Energiebereiche zeigen, welche alle vorhanden sind.

In entsprechender Weise zeigt die **Fig. 7** einen Schnitt durch die Selektionsblende 6 mit diesen beispielhaften Fokussen 10, 10' und 10'', wobei natürlich Energien zwischen 10' und 10'' auf der Selektionsblende 6 auftreffen und nur der gewünschte Energieintervall 7 durchgelassen wird. Dabei zeigen die beiden Kegel (wegen des oben erläuterten Verlaufs des Teilchenstroms weisen alle dargestellten Kegel elliptische Querschnitte auf) mit den Spitzen im Punktfokus 10 beispielhaft die Zusammenführung aller Teilchen der exakten Energie, die dem Achsverlauf E entspricht. Man muß sich die Darstellung natürlich dahingehend ergänzen, daß ein Strich, der vom Punktfokus 10' bis zum Punktfokus 10'' reicht, mit solchen Punktfokussen verschiedener Energien gefüllt sind. Dies ist in **Fig. 7a** verdeutlicht, wobei dort aufgezeigt ist, daß die Blende 6 nur das gewünschte Energieintervall 7 hindurchläßt. Die Blendenöffnung der Blende 6 kann dabei natürlich eine nahezu beliebige Form haben, es muß nur eindeutig der Strich zwischen 10' und 10'' auf das Energieintervall 7 begrenzt werden, auch wenn die genaue Lage des Teilchenstroms unter Umständen gewisse Abweichungen aufweist. Deshalb ist eine viereckige Blendenöffnung sinnvoll.

Die **Fig. 8** zeigt eine Schlitzblende 29 des eingangs gewürdigten Standes der Technik, um die Unterschiede zu verdeutlichen. Da es hier zu keinen Punktfokussen 10, 10', 10'' kommt, sondern zu Linienfokussen 31, 31', 31'' die man sich als lauter parallel verlaufende Linien zwischen dem Linienfokus 31' der geringsten Energie und dem Linienfokus 31'' der stärksten Energie vorstellen muß, ist es hier erforderlich, daß der gewünschte Energieintervall 7 durch eine Schlitzblende 29 ausgeblendet wird. Darum besteht das Problem in der eingangs beschriebenen Weise darin, daß eine solche Schlitzblende 29 exakte Seitenbegrenzungen 29', 29'' aufweisen muß.

Diese Seitenbegrenzungen 29', 29''sind in **Fig. 8** in übertriebener Weise fehlerhaft dargestellt in Form einer Erweiterung a und einer Verengung b, wobei natürlich Schmutzbestandteile denselben Effekt auslösen würden. Diese verschiedenen Weiten a und b der Schlitzblende 29 führen zu einer Intensitätsverteilung der Stromdichte über das Bild, die in **Fig. 8a** gezeichnet ist. Korrelierend zu dieser Intensitätsverteilung ist daneben ein Bild **8b** gezeichnet, das der Stromdichte entsprechende Intensitätsunterschiede aufweist, die hier durch Linien angedeutet sind, welche einen hellen Bildbereich 33 und einen dunkleren Bildbereich 34 darstellen sollen. Derartige Bilder 32 durch Fehler oder Schmutz von Schlitzblenden 29 des Standes der Technik können dann dazu führen, daß intensitätsschwache Bilder derart durch diese Intensitätsunterschiede überdeckt werden, daß eine Auswertung nicht mehr möglich ist.

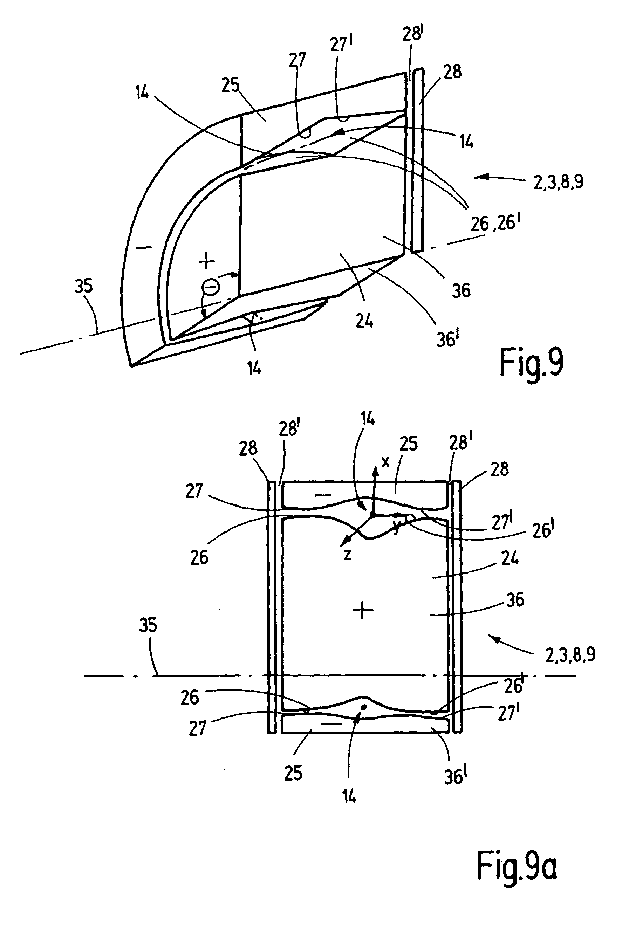

**Fig. 9** zeigt eine Ausführungsform eines Ablenkelements 2, 3, 8 oder 9 der Erfindung, wobei dieses aus einer inneren Elektrode 24 und einer äußeren Elektrode 25 besteht. Die innere Elektrode 24 weist kegelstumpfförmige Flächen 26, 26' auf, die V-förmig ausgebildet sind und wobei dieses "V" einem anderen "V" gegenübersteht, das aus den kegelstumpfförmigen Flächen 27, 27' der äußeren Elektrode 25 gebildet wird. Auf diese Weise wird ein rhomboidförmiger Kreisringraum (Toroid - zur Berechnung nach der SCOFF-Näherung) gebildet, der über den gesamten Winkelbereich des Bogenwinkels $\theta$ des jeweiligen Ablenkelements 2, 3, 8 oder 9 verläuft. Zentral zu den Flächen 26, 26', 27, 27' verläuft die Ablenkbahn 14, welche auf diese Weise den mit der strichpunktierten Linie gezeigten Bogen aufweist. Auf diese Weise werden die Bögen gebildet, welche oben in den Figuren 1, 2, 4a, 5a und 6a gezeigt wurden. Selbstverständlich besteht auch am Rande der Elektroden 24, 25 ein schmaler Spalt, da sich diese schließlich auf verschiedenen elektrischen Potentialen befinden, wie dies durch das Plus und das Minus angezeigt ist. Diese Spalte sind wiederum mit einem Spalt 28' durch Platten 28 auf Nullpotential abgedeckt. Dabei ist die vordere Platte weggelassen, um den Verlauf des Spalts zwischen den Elektroden 24 und 25 sichtbar zu machen. Durch die Achse 35 ist noch gezeigt, wo sich die Drehachse befindet, durch welche diese Elektroden auf einem Drehautomaten oder einer ähnlichen Werkzeugmaschine hergestellt werden können. Nicht dargestellt sind die Abschirmplatten, die mit einem Spalt gegenüber den Flächen 36, 36' der Ablenkelemente 2, 3, 8, 9 angeordnet sind, die senkrecht zur Achse E, also zur Ablenkbahn 14 ausgerichtet sind. Diese Abschirmplatten weisen jeweils kleine Bohrungen im Bereich der Ablenkbahn 14 als Durchtrittsöffnungen für den Ladungsteilchenstrom auf und liegen ebenfalls auf Extraktorpotential. Diese Abschirmplatten können mit den vorgenannten Platten kastenförmige Abschirmungen der Ablenkelemente 2, 3, 8, 9 bilden.

**Fig. 9a** zeigt eine weitere Ausführungsform eines Ablenkelements 2, 3, 8 oder 9, wobei hier der Blick senkrecht auf die auch in der Fig. 9 eingezeichnete Fläche 36 gerichtet ist. Im Unterschied zum oben beschriebenen Ausführungsbeispiel sind hier die Flächen 27, 27' der äußeren Elektrode 25 und die Flächen 26 und 26' der inneren Elektrode 24 gekrümmt. Hier sind die x-, y- und z-Achsen des krummlinigen Raumkoordinatensystems eingezeichnet, wobei die z-Achse hier senkrecht aus der Bildebene herauskommt und dem Verlauf der Ablenkbahn 14 folgt. Die gekrümmten Flächen 26, 26', 27, 27' sind symmetrisch zur x-Ebene und weisen entlang der z-Achse immer gleiche Abstände und Krümmungen auf. Daß die Kontur auf der Fläche 36' gegenüber der Fläche 36 verformt ist, kommt lediglich daher, daß der Blick auf die Fläche 36 senkrecht ist, die Fläche 36' jedoch schräg nach hinten verläuft.

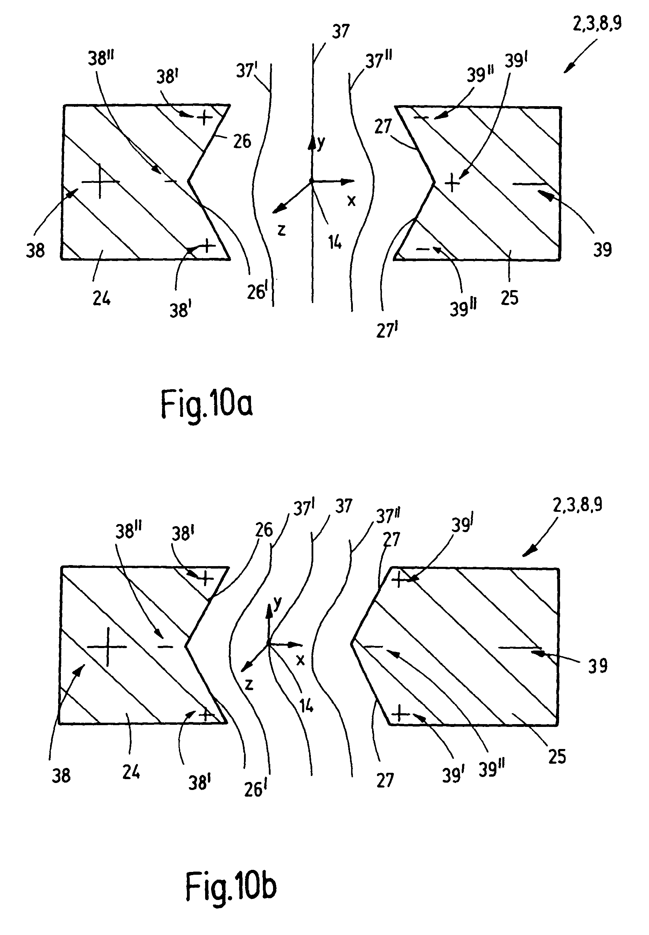

**Fig. 10a** zeigt eine Prinzipskizze des Querschnitts eines Ablenkelements 2, 3, 8, 9 mit Bildung eines Hexapols. Dabei entspricht dieser Querschnitt dem schon in Fig. 9 gezeigten Querschnitt. Bei jedem Ablenkelement 2, 3, 8, 9 bilden die Elektroden 24, 25 zunächst einen Dipol, welcher zur Erzeugung der gewünschten Ablenkbahn 14 ausreicht. Dabei müssen immer nur die dafür erforderlichen Bögen mit den entsprechenden Bogenwinkeln $\theta$ zusammengesetzt werden. Ein solcher aus Dipolen zusammengesetzter Monochromator 1 würde jedoch seinerseits wieder Bildfehler erzeugen. Diese können durch den Einsatz von Multipolelementen minimiert werden. Multipolelemente im hier verwendeten Sinn sind keine reinen Multipolelemente - wenn diese der Fachmann (siehe Kahl a.a.O.) auch so nennt -, sondern es handelt sich um Dipole mit einer Überlagerung durch einen Multipol. Ablenkelemente können dabei durch ihre geometrische Form zu solchen von Multipolen überlagerten Dipolen ausgebildet werden.

Als Beispiel für einen auf diese Weise geschaffenen Hexapol zeigt die Fig. 10a eine Prinzipskizze einer möglichen geometrischen Form. Bei dieser Form, welche Flächen 26, 26', 27, 27' aufweist, die im Schnitt zwei mit den Öffnungen zueinanderweisende "V" bilden, kommt es zu einer bestimmten Formung der Äquipotentiallinien 37, 37', 37". Durch eine Symmetrie zur - entsprechend der Ablenkbahn 14 - gekrümmten x-z-Fläche verläuft das Nullpotential 37 in der x-y-Ebene als Gerade durch die Elektroden 24, 25 hindurch. Dagegen kommt es bei den Äquipotentiallinien 37' und 37" zu Krümmungen infolge von Potentialabweichungen auf den Elektroden 24, 25 durch deren Geometrie. So hat das Potential 38 der inneren Elektrode 24 zwei positive 38' und eine negative 38" Abweichung, die symmetrisch angeordnet sind. Dies gilt in entsprechender Weise für das Potential 39 der äußeren Elektrode 25 mit einer positiven 39' und zwei negativen 39" Abweichungen. Die zeichnerischen Äquipotentiallinien 37', 37" sind dabei in z-Richtung gekrümmte Äquipotentialflächen 37', 37", welche den Verlauf der Ablenkbahn 14 bestimmen. Durch entsprechende Berechnung der Geometrie der Flächen 26, 26', 27, 27' lassen sich diese Äqupotentialflächen 37, 37', 37" derart berechnen (siehe oben, Kahl a. a. O.), daß die durch den Monochromator 1 verursachten Bildfehler minimiert sind. Durch einen Hexapol lassen sich Bildfehler zweiter Ordnung korrigieren.

**Fig. 10b** zeigt eine andere geometrische Form der Flächen 26, 26', 27, 27' von Elektroden 24, 25. Diese weisen keine Symmetrie gegenüber dem yz-Schnitt auf, wodurch die Äquipotentiallinie 37 des als Nullpotential definierten Extraktorpotentials gekrümmt verläuft und auch die anderen Äquipotentiallinien (bzw. -flächen) 37', 37" entsprechend gekrümmt geformt sind. Mit der beispielhaft dargestellten Geometrie läßt sich ein durch einen Quadrupol überlagerter Dipol ausbilden. Damit lassen sich weitere Variationen der unterschiedlichen Brechkräfte im xz- und yz-Schnitt einstellen. Selbstverständlich sind auch Multipolelemente höherer Ordnung möglich, sofern Bildfehler höherer Ordnung korrigiert werden sollen.

Selbstverständlich können die Zeichnungen nur einen kleinen Ausschnitt dessen wiedergeben, wie die Erfindung realisierbar ist. So können die Formen der Ablenkbahn 14 auch andere Ausgestaltungen aufweisen und es wäre selbstverständlich auch möglich, mehr als vier Ablenkelemente 2, 3, 8, 9 vorzusehen. Ebenso kann die Form der Elektroden 24 und 25 in verschiedenster Weise aufgebaut werden, statt der Flächen 26, 26', 27, 27' könnten auch sonstige verschiedenste Formen Anwendung finden. Wesentlich ist lediglich, daß sie weit genug von der Punktsymmetrie einer Kugelform abweichen, damit es nicht zu Punktfokussen innerhalb der Ablenkfelder 2', 3', 8', 9' kommt.

**Bezugszeichenliste**

| | |
|---|---|
| 1 | Monochromator |
| 2, 3 | Ablenkelemente |
| 2', 3' | Ablenkfelder |
| 4 | Dispersion |
| 4' | Eliminierung der Dispersion |
| 5 | Ebene der Selektionsblende |
| 5' | Symmetrieebene des Monochromators |
| 6 | Selektionsblende |
| 7 | gewünschtes Energieintervall |
| 8, 9 | Ablenkelemente |
| 8', 9' | Ablenkfelder |
| 10 | Punktfokus des gewünschten Energieintervalls |
| 10' | Punktfokus (geringste Energie) |
| 10" | Punktfokus (stärkste Energie) |
| 11 | Nulldurchgänge $x_\alpha$ |
| 12 | Nulldurchgänge $y_\beta$ |
| 13 | Umkehrpunkte |
| 14 | Ablenkbahn |
| 15 | Änderungen der Bahnkrümmungen der Ladungsteilchen $y_\beta$ |
| 16 | Eingang des Monochromators |
| 16' | Ausgang des Monochromators |
| 17 | Strahlquelle |
| x, y, z | räumliche Koordinaten, wobei die optische Achse E in der z-Achse liegt und x und y eine dazu senkrecht Ebene angeben, in denen die Auslenkungen der Ladungsteilchen $x_\alpha$ und $y_\beta$ stattfinden |
| E | optische Achse des Monochromators |

| | |
|---|---|
| E-dE | Achsabweichung von Teilchen niedrigster Energie |
| E+dE | Achsabweichung von Teilchen höchster Energie |
| E' | Ort auf der optischen Achse |
| Es | optische Achse am Eingang des Monochromators |
| $E_A$ | optische Achse am Ausgang Monochromator |
| A | Auslenkungen der Ladungsteilchen zur optischen Achse |
| $\alpha$ | Winkel der Bahn der Ladungsteilchen eines x-Schnitts zur optischen Achse beim Eintritt in den Monochromator |
| $\beta$ | Winkel der Bahn der Ladungsteilchen eines y-Schnitts zur optischen Achse beim Eintritt in den Monochromator |
| $x_{\alpha}$, | Ladungsteilchen eines x-Schnitts mit $\alpha$ = max., $\beta$ = 0 |
| $y_{\beta}$ | Ladungsteilchen eines y-Schnitts mit $\beta$ = max., $\alpha$ = 0 |
| $\theta$ | Bogenwinkel der bogenförmigen Ablenkelemente |
| $\varphi+$, $\varphi-$ | Potentiale der Elektroden der Ablenkelemente |
| 18 | Strahldurchtritt |
| 19 | virtueller Eingangs-Crossover |
| 20 | virtueller Ausgangs-Crossover |
| 21 | elektrostatische Linse |
| 22 | Blende |
| 23 | Teilchenstrom der Strahlquelle |
| 23' | durch Linse und Blende regulierter und begrenzter Teilchenstrom |
| 24 | innere Elektrode |
| 25 | äußere Elektrode |
| 26, 26' | kegelstumpfförmige Flächen der inneren Elektrode (als Ausschnitt aus einer Kegelstumpfmantelfläche) |
| 27, 27' | kegelstumpfförmige Flächen der äußeren Elektrode (als Ausschnitt aus einer Kegelstumpfmantelfläche) |
| 28 | Platten auf Nullpotential |
| 28' | Spalt |
| 29 | Schlitzblende des Standes der Technik |
| 29', 29" | Seitenbegrenzungen der Schlitzblende |
| 30 | Strahl mit viereckigem Querschnitt |
| 31 | Linienfokus der gewünschten Energie |

31'        Linienfokus (zu geringe Energie)

31 "       Linienfokus (zu starke Energie)

32         Bild des Standes der Technik
           a Erweiterung der Schlitzblende
           b Verengung der Schlitzblende

33         heller Bildbereich

34         dunkler Bildbereich

35         Drehachse bei der Herstellung der Elektroden

36, 36'    Flächen der Ablenkelemente senkrecht zur Achse (E)

37, 37', 37"    Äquipotentiallinien (bzw. -flächen)

37         Nullpotential (Extraktorpotential)

37'        positives Potential

37"        negatives Potential

38         positives Potential der inneren Elektrode

38'        positive Abweichung

38"        negative Abweichung

39         negatives Potential der äußeren Elektrode

39'        positive Abweichung

39"        negative Abweichung

**Patentansprüche**

1. Monochromator (1) für eine Ladungsteilchenoptik, insbesondere für die Elektronenmikroskopie, mit mindestens einem ersten Ablenkelement (2, 3) mit einem elektrostatischen Ablenkfeld (2', 3') zur Erzeugung einer Dispersion (4) in einer Ebene (5) mit einer Selektionsblende (6) zur Selektion der Ladungsteilchen des gewünschten Energieintervalls (7) und mindestens einem zweiten Ablenkelement (8, 9) mit einem elektrostatischen Ablenkfeld (8', 9'), das die Dispersion (4) des mindestens einen ersten Ablenkfeldes (2', 3') eliminiert, wobei

   die Ablenkelemente (2, 3, 8, 9) derart von einer sphärischen Form abweichend ausgebildet und ihre Elektroden (24, 25) mit einem derartigen Potential ($\varphi+$, $\varphi-$) beaufschlagt sind, daß die axialen Fundamentalbahnen ($x_\alpha$, $y_\beta$) der Ladungsteilchen, die in verschiedenen Schnitten (x, y) jeweils unter einem Winkel ($\alpha$, $\beta$) virtuell in ein Bild einer Strahlquelle (17) mit einem Nulldurchgang beider axialer Fundamentalbahnen ($x_\alpha$, $y_\beta$ einlaufen, derart unterschied-lich fokussiert werden, daß es ausschließlich in der Ebene (5) der Selektionsblende (6) zu einem stigmatischen Bild der Strahlquelle (17) mit einer Punktfokussierung (10, 10', 10") von Ladungsteilchen ($x_\alpha$, $y_\beta$) einer Energie kommt, da im gesamten Monochromator (1) nur dort Nulldurchgänge (11, 12) der axialen Fundamentalbahnen ($x_\alpha$, $y_\beta$) der Ladungsteilchen der verschiedenen Schnitte (x, y) bei der gleichen Position (E') auf der optischen Achse (E) aufeinandertreffen.

2. Monochromator nach Anspruch 1,
   **dadurch gekennzeichnet,**
   **daß** die Ablenkfelder (2', 3', 8', 9') der Ablenkelemente (2, 3, 8, 9) derart ausgebildet sind, daß es außer den Nulldurchgängen (11, 12) der Ablenkungen (A) der Ladungsteilchen ($x_\alpha$, $y_\beta$) verschiedener Schnitte (x, y) in der Ebene (5) der Selektionsblende (6) zu keinen weiteren Fokussen im Monochromator (1) kommt.

**3.** Monochromator nach Anspruch 1,
**dadurch gekennzeichnet,**
**daß** die Ablenkelemente (2, 3, 8, 9) derart ausgebildet sind, daß die Ablenkfelder (2', 3', 8', 9') Umkehrpunkte (13) in der Auslenkung (A) der Ladungsteilchen $(x_\alpha)$ der x-Richtung mit dazwischen liegenden Nulldurchgängen (11) durch die Achse (E) einer Ablenkbahn (14) verursachen, jedoch in der senkrecht zur x-Richtung verlaufenden y-Richtung lediglich Änderungen der Bahnkrümmungen (15) mit einem einzigen Nulldurchgang (12) durch die optische Achse (E, z) im Bereich der Selektionsblende (6).

**4.** Monochromator nach Anspruch 1, 2 oder 3,
**dadurch gekennzeichnet,**
**daß** die Elektroden (24, 25) der Ablenkelemente (2, 3, 8, 9) im Wesentlichen als Abschnitte von Toroiden ausgebildet sind, deren Flächen (26, 26', 27, 27') in einem entlang der z-Achse krummlinigen orthogonalen Koordinatensystem (x, y, z), bei dem die z-Achse der optischen Achse (E) des Monochromators (1) entspricht, symmetrisch zum xz-Schnitt verlaufen, zur z-Achse für jeden Ort auf derselben die gleichen Abstände aufweisen und in der x-y-Ebene derart von geraden Linien abweichend geformt sind, daß von den Elektroden (24, 25) gebildeten Dipole durch Multipole überlagert werden, wobei die Flächen (26, 26', 27, 27') der Elektroden (24, 25) derart ausgestaltet sind, daß durch die Multipole die durch den Monochromator (1) verursachten Öffnungsfehler minimiert werden können.

**5.** Monochromator nach Anspruch 4,
**dadurch gekennzeichnet,**
**daß** die Multipole Quadrupole sind.

**6.** Monochromator nach Anspruch 4,
**dadurch gekennzeichnet,**
**daß** die Multipole Hexapole sind.

**7.** Monochromator nach Anspruch 4, 5 oder 6,
**dadurch gekennzeichnet,**
**daß** die Flächen der Elektroden (24, 25) gekrümmt sind.

**8.** Monochromator nach Anspruch 4, 5 oder 6,
**dadurch gekennzeichnet,**
**daß** die Elektroden (24, 25) Flächen (26, 26', 27, 27') in Form eines Ausschnittes aus einem Kegelstumpf aufweisen.

**9.** Monochromator nach Anspruch 8,
**dadurch gekennzeichnet,**
**daß** die Flächen (26, 26', 27, 27') zwei "V" bilden, die mit den Spitzen in die gleiche Richtung weisen.

**10.** Monochromator nach Anspruch 8,
**dadurch gekennzeichnet,**
**daß** die Flächen (26,26', 27,27') zwei "V" bilden, die mit den Öffnungen zueinander weisen.

**11.** Monochromator nach einem der Ansprüche 1 bis 10
**dadurch gekennzeichnet,**
**daß** er um eine Ebene (5') symmetrisch aufgebaut ist und diese Symmetrieebene (5') mit der Ebene (5) der Selektionsblende (6) identisch ist.

**12.** Monochromator nach einem der Ansprüche 1 bis 11,
**dadurch gekennzeichnet,**
**daß** die optische Achse (E) des Monochromators (1) die Form einer geschlossenen Schlaufe mit der Abweichung aufweist, daß die optischen Achsen der Schlaufe nicht völlig ineinander laufen dürfen.

**13.** Monochromator nach einem der Ansprüche 1 bis 11,
**dadurch gekennzeichnet,**
**daß** die optische Achse $(E_A)$ am Ausgang (16') des Monochromators (1) mit der Verlängerung der optischen Achse (Es) am Eingang (16) des Monochromators (1) übereinstimmt.

**14.** Monochromator nach Anspruch 13,
**dadurch gekennzeichnet,**
**daß** die optische Achse E des Monochromators (1) im Wesentlichen die Form eines Ω aufweist.

**15.** Monochromator nach Anspruch 14,
**dadurch gekennzeichnet,**
**daß** die Ω-form durch zwei Ablenkelemente (2, 3) vor der Selektionsblende (6) und zwei Ablenkelementen (8, 9) nach der Selektionsblende (6) gebildet wird, wobei die Ablenkelemente (2, 3, 8, 9) kreisbogenförmige Ablenkbahnen (14) aufweisen, die jeweils einen Bogenwinkel (θ) zwischen 120° und 150° aufweisen.

**16.** Monochromator nach Anspruch 13, 14 oder 15,
**dadurch gekennzeichnet,**
**daß** die Ablenkelemente (2, 9) einen Strahldurchtritt (18) in Richtung der optischen Achse ($E_S$) am Eingang (16) und der optischen Achse ($E_A$) am Ausgang (16') des Monochromators (1) aufweisen, so daß sich beim Ausschalten des Monochromators (1) die Ladungsteilchen entlang der optischen Achse ($E_A$) zum Ausgang (16') des Monochromators (1) bewegen.

**17.** Monochromator nach einem der Ansprüche 12 bis 16 zumindest indirekt rückbezogen auf Anspruch 11,
**dadurch gekennzeichnet,**
**daß** das durch die in verschiedenen Schnitten jeweils virtuell ein Laufenden Ladungsteilchen gebildete Bild der Strahlungsquelle (17) als ein virtueller Eingangs-Crossover (19) und ein virtueller Ausgangs-Crossover (20) des Monochromators (1) in der Symmetrieebene (5') des Monochomators zusammenfällen.

**18.** Monochromator nach einem der Ansprüche 1 bis 17,
**dadurch gekennzeichnet,**
**daß** die Elektroden (24, 25) außen mit parallel zur Achse (E) ausgerichteten Platten (28) auf ein Extraktorpotential abgeschirmt sind.

**19.** Monochromator nach Anspruch 18,
**dadurch gekennzeichnet,**
**daß** die Elektroden (24, 25) an ihren Flächen (36, 36'), die senkrecht zur Achse (E) ausgerichtet sind, Abschirmplatten auf dem Extraktorpotential aufweisen, die Durchtrittsöffnungen für den Ladungsteilchenstrom aufweisen.

**20.** Monochromator nach den Ansprüchen 18 und 19,
**dadurch gekennzeichnet,**
**daß** die Elektroden (24, 25) kastenförmige Abschirmungen auf Extraktorpotential mit Durchtrittsöffnungen für den Ladungsteilchenstrom aufweisen.

**21.** Strahlquelle mit einem Monochromator nach einem der Ansprüche 1 bis 20
**dadurch gekennzeichnet,**
**daß** dem Monochromator (1) eine Strahlquelle (17) mit einer elektrostatischen Linse (21) und einer Blende (22) zur Regulierung und Begrenzung des Teilchenstroms (23, 23') vorgeordnet ist, wobei die Linse (21) ein virtuelles Bild der Strahlquelle (17) erzeugt, das hinter dem Eingang (16) des Monochromators (1) liegt.


**Claims**

**1.** Monochromator (1) for a charged particle optics, in particular, for electron microscopy, comprising at least one first deflection element (2, 3) with an electrostatic deflecting field (2', 3') for generating a dispersion (4) in the plane (5) of a selection aperture (6) for selecting the charged particles of a desired energy interval (7), and at least one second deflection element (8, 9) with an electrostatic deflecting field (8', 9') which eliminates the dispersion (4) of the at least one first deflecting field (2', 3'), wherein the deflection elements (2, 3, 8, 9) have a design other than spherically shaped and their electrodes (24, 25) are given a potential ($\varphi_+,\ \varphi_-$) such that the axial fundamental rays ($x_\alpha$, $y_\beta$) of the charged particles which virtually enter into an image of a radiation source (17) at respective angles ($\alpha$, $\beta$) in different sections (x, y), with a zero crossing of both axial fundamental rays ($x_\alpha$, $y_\beta$) are differently focussed, such that charged particles ($x_\alpha$, $y_\beta$) of one energy are point focussed (10, 10', 10") to a stigmatic image of the radiation source (17) exclusively in the plane (5) of the selection aperture (6), since zero-crossings (11, 12) of the axial fundamental rays ($x_\alpha$, $y_\beta$) of the charged particles of the different sections (x, y) only coincide there at the same position (E') along the optical axis (E).

2. Monochromator according to claim 1, **characterized in that** the deflecting fields (2', 3', 8', 9') of the deflection elements (2, 3, 8, 9) are designed in such a fashion that there are no further focuses in the monochromator (1) except for the zero-crossings (11, 12) of the deflections (A) of the charged particles ($x_\alpha$, $y_\beta$) of different sections (x, y) in the plane (5) of the selection aperture (6).

3. Monochromator according to claim 1, **characterized in that** the deflection elements (2, 3, 8, 9) are designed in such a fashion that the deflecting fields (2', 3', 8', 9') cause reversal points (13) in the deflection (A) of the charged particles ($x_\alpha$) of the x direction with intermediate zero-crossings (11) through the axis (E) of the deflection path (14), however, in the y direction that extends perpendicularly to the x direction, only cause changes of the path curvatures (15) with one single zero-crossing (12) through the optical axis (E, z) in the area of the selection aperture (6).

4. Monochromator according to claims 1, 2, or 3, **characterized in that** the electrodes (24, 25) of the deflection elements (2, 3, 8, 9) are substantially designed as sections of toroids, whose surfaces (26, 26', 27, 27') extend symmetrically to the xz section in a coordinate system (x, y, z) which is orthogonal and curved along the z axis and in which the z axis corresponds to the optical axis (E) of the monochromator (1), have the same separations from the z axis at any location thereon, and have a shape in the xy plane which differs from straight lines, such that the dipoles formed by the electrodes (24, 25) are superposed by multipoles, wherein the surfaces (26, 26', 27, 27') of the electrodes (24, 25) are designed in such a fashion that the aperture aberrations caused by the monochromator (1) can be compensated by the multipoles.

5. Monochromator according to claim 4, **characterized in that** the multipoles are quadrupoles.

6. Monochromator according to claim 4, **characterized in that** the multipoles are hexapoles.

7. Monochromator according to claim 4, 5, or 6, **characterized in that** the surfaces of the electrodes (24, 25) are curved.

8. Monochromator according to claim 4, 5, or 6, **characterized in that** the electrodes (24, 25) comprise surfaces (26, 26', 27, 27') in the form of a section from a truncated cone.

9. Monochromator according to claim 8, **characterized in that** the surfaces (26, 26', 27, 27') form two "V"s whose tips point in the same direction.

10. Monochromator according to claim 8, **characterized in that** the surfaces (26, 26', 27, 27') form two "V"s with their openings facing towards each other.

11. Monochromator according to any one of the claims 1 through 10, **characterized in that** it has a symmetrical design about the plane (5') and this symmetry plane (5') corresponds to the plane (5) of the selection aperture (6).

12. Monochromator according to any one of the claims 1 through 11, **characterized in that** the optical axis (E) of the monochromator (1) has substantially the shape of a closed loop, with the constraint that the optical axes of the loop cannot run completely within another.

13. Monochromator according to any one of the claims 1 through 11, **characterized in that** the optical axis ($E_A$) at the exit (16') of the monochromator (1) corresponds to the extension of the optical axis ($E_S$) at the entry (16) of the monochromator (1).

14. Monochromator according to claim 13, **characterized in that** the optical axis E of the monochromator (1) has substantially the shape of an $\Omega$.

15. Monochromator according to claim 14, **characterized in that** the $\Omega$ shape is formed by two deflection elements (2, 3) upstream of the selection aperture (6) and two deflection elements (8, 9) downstream of the selection aperture (6), wherein the deflection elements (2, 3, 8, 9) have circular arc shaped deflection paths (14) which each have an arc angle ($\theta$) between 120° and 150°.

16. Monochromator according to claim 13, 14, or 15, **characterized in that** the deflection elements (2, 9) comprise a beam passage (18) in the direction of the optical axis ($E_S$) at the input (16) and of the optical axis ($E_A$) at the output (16') of the monochromator (1) such that when the monochromator (1) is switched off, the charged particles also move along the optical axis ($E_A$) to the output (16') of the monochromator (1).

17. Monochromator according to any one of the claims 12 through 16 and at least indirectly dependent on claim 1, **characterized in that** the image of the radiation source (17) formed by the charged particles virtually running in differing respective sections coincide in the symmetry plane (5') of the monochromator as a virtual input crossover (19) and a virtual output crossover (20) of the monochromator (1).

18. Monochromator according to any one of the claims 1 through 17, **characterized in that** the electrodes (24, 25) are externally shielded with plates (28) at an extractor potential, which are oriented parallel to the axis (E).

19. Monochromator according to claim 18, **characterized in that**, at their surfaces (36, 36') which are oriented perpendicularly to the axis (E), the electrodes (24, 25) have shielding plates at the extractor potential having passage openings for the charged particle current.

20. Monochromator according to claims 18 and 19, **characterized in that** the electrodes (24, 25) have box-shaped shieldings at extractor potential with passage openings for the charged particle current.

21. Radiation source with a monochromator according to any one of the claims 1 through 20, **characterized in that** a radiation source (17) with electrostatic lens (21) and an aperture (22) are placed upstream of the monochromator (1) for regulating and limiting the charged particle current (23, 23'), wherein the lens (21) generates a virtual image of the radiation source (17) which is downstream of the entrance (16) of the monochromator (1).

**Revendications**

1. Monochromateur (1) pour une optique à particules de charge, en particulier pour la microscopie électronique, comprenant au moins un premier élément de déviation (2, 3) avec une zone de déviation électrostatique (2', 3') pour générer une dispersion (4) dans un plan (5) avec un obturateur de sélection (6) pour la sélection des particules de charge de l'intervalle d'énergie souhaité (7), et au moins un second élément de déviation (8, 9) avec une zone de déviation (8', 9') électrostatique, qui élimine la dispersion (4) de la au moins une première zone de déviation (2', 3'), les éléments de déviation (2, 3, 8, 9) étant conçus différemment d'une forme sphérique et leurs électrodes (24, 25) étant alimentées avec un potentiel (φ+, φ-) tel que les bandes fondamentales axiales ($x_\alpha$, $y_\beta$) des particules de charge, qui arrivent dans différentes coupes (x, y) à chaque fois sous un angle (α, β) de façon virtuelle dans une image d'une source de faisceau (17) avec un passage par zéro des deux bandes fondamentales axiales ($x_\alpha$, $y_\beta$), sont focalisées différemment de telle sorte qu'on arrive uniquement dans le plan (5) de l'obturateur de sélection (6) à une image stigmatique de la source de faisceau (17) avec une focalisation ponctuelle (10, 10', 10") de particules de charge ($x_\alpha$, $y_\beta$) d'une l'énergie, étant donné que, dans l'ensemble du monochromateur (1), des passages par zéro (11, 12) des bandes fondamentales axiales ($x_\alpha$, $y_\beta$) des particules de charge des différentes coupes (x, y) se rencontrent seulement à cet endroit avec la même position (E') sur l'axe optique (E).

2. Monochromateur selon la revendication 1,
**caractérisé en ce que**
les zones de déviation (2', 3', 8', 9') des éléments de déviation (2, 3, 8, 9) sont conçues de telle sorte que, en dehors des passages par zéro (11, 12) des déviations (A) des particules de charge ($x_\alpha$, $y_\beta$) de différentes coupes (x, y) dans le plan (5) de l'obturateur de sélection (6), on n'arrive pas à d'autres foyers dans le monochromateur (1).

3. Monochromateur selon la revendication 1,
**caractérisé en ce que**
les éléments de déviation (2, 3, 8, 9) sont conçus de telle sorte que les zones de déviation (2', 3', 8', 9') entraînent des points d'inversion (13) dans la déviation (A) des particules de charge ($x_\alpha$) de la direction x avec des passages par zéro (11) intercalés par l'axe (E) d'une bande de déviation (14), mais, dans la direction y s'étendant perpendiculairement à l'axe x, uniquement des modifications des courbures de bande (15) avec un unique passage par zéro (12) par l'axe optique (E, z), dans la zone de l'obturateur de sélection (6).

4. Monochromateur selon la revendication 1, 2 ou 3,
**caractérisé en ce que**
les électrodes (24, 25) des éléments de déviation (2, 3, 8, 9) sont conçues sensiblement sous forme de parties de toroïdes, dont les surfaces (26, 26', 27, 27') sont agencées dans un système de coordonnées (x, y, z) orthogonal, à ligne courbe, le long de l' axe z, dans lequel l'axe z correspond à l'axe optique (E) du monochromateur (1), de façon symétrique par rapport à la coupe xz, présentent les mêmes espacements par rapport à l'axe z pour chaque emplacement sur celui-ci et sont formées dans le plan x-y différemment des lignes droites, de telle sorte que des dipôles formés par les électrodes (24, 25) sont superposées par des multipôles, les surfaces (26, 26', 27, 27') des électrodes (24, 25) étant conçues de telle sorte que les erreurs d'ouverture provoquées par le monochromateur (1) peuvent être minimisées par les multipôles.

**5.** Monochromateur selon la revendication 4,
   **caractérisé en ce que**
   les multipôles sont des quadripôles.

**6.** Monochromateur selon la revendication 4,
   **caractérisé en ce que**
   les multipôles sont des hexapôles.

**7.** Monochromateur selon la revendication 4, 5, ou 6,
   **caractérisé en ce que**
   les surfaces des électrodes (24, 25) sont incurvées.

**8.** Monochromateur selon la revendication 4, 5 ou 6,
   **caractérisé en ce que**
   les électrodes (24, 25) présentent des surfaces (26, 26', 27, 27') sous la forme d'un extrait d'un cône tronqué.

**9.** Monochromateur selon la revendication 8,
   **caractérisé en ce que**
   les surfaces (26, 26', 27, 27') forment deux "V", qui sont dirigées avec les extrémités dans la même direction.

**10.** Monochromateur selon la revendication 8,
   **caractérisé en ce que**
   les surfaces (26, 26', 27, 27') forment deux "V", qui sont dirigées avec les ouvertures les unes vers les autres.

**11.** Monochromateur selon l'une des revendications 1 à 10,
   **caractérisé en ce**
   **qu'**il est conçu de façon symétrique autour d'un plan (5') et ce plan de symétrie (5') est identique au plan (5) de l'obturateur de sélection (6).

**12.** Monochromateur selon l'une des revendications 1 à 11,
   **caractérisé en ce que**
   l'axe (E) optique du monochromateur (1) présente la forme d'une boucle fermée avec la différence que le les axes optiques de la boucle ne peuvent pas s'engager complètement les uns dans les autres.

**13.** Monochromateur selon l'une des revendications 1 à 11,
   **caractérisé en ce que**
   l'axe optique ($E_A$) à la sortie (16') du monochromateur (1) coïncide avec le prolongement de l'axe optique ($E_S$) à l'entrée (16) du monochromateur (1).

**14.** Monochromateur selon la revendication 13,
   **caractérisé en ce que**
   l'axe optique E du monochromateur (1) présente sensiblement la forme d'un $\Omega$.

**15.** Monochromateur selon la revendication 14,
   **caractérisé en ce que**
   la forme $\Omega$ est formée par deux éléments de déviation (2, 3) avant l'obturateur de sélection (6) et deux éléments de déviation (8, 9) après l'obturateur de sélection (6), les éléments de déviation (2, 3, 8, 9) présentant des bandes de déviation (14) en forme d'arc de cercle, qui présentent chacune un angle d'arc ($\theta$) compris entre 120° et 150°.

**16.** Monochromateur selon la revendication 13, 14 ou 15,

**caractérisé en ce que**
les éléments de déviation (2, 9) présentent un passage de faisceau (18) en direction de l'axe optique ($E_S$) à l'entrée (10) et de l'axe optique ($E_A$) à la sortie (16') du monochromateur de sorte que, lors de la déconnexion du monochromateur (1), les particules de charge se déplacent le long de l'axe optique ($E_A$) vers la sortie (16') du monochromateur (1).

17. Monochromateur selon l'une des revendications 12 à 16, rapporté au moins indirectement à la revendication 1,
**caractérisé en ce que**
l'image, formée par les particules de charge entrant à chaque fois virtuellement dans différentes coupes, de la source de rayonnement (17) sous la forme d'une section transversale d'entrée (19) virtuelle et celle sous la forme d'une section transversale de sortie (20) virtuelle du monochromateur (1) coïncident dans le plan de symétrie (5') du monochromateur.

18. Monochromateur selon l'une des revendications 1 à 17,
**caractérisé en ce que**
les électrodes (24, 25) sont protégées à l'extérieur avec des plaques (28) orientées parallèlement à l'axe (E) par rapport à un potentiel extracteur.

19. Monochromateur selon la revendication 18,
**caractérisé en ce que**
les électrodes (24, 25) présentent sur leurs surfaces (36, 36'), qui sont orientées perpendiculairement à l'axe (E), des plaques de blindage sur le potentiel extracteur, lesquelles présentent des ouvertures de passage pour le flux de particules de charge.

20. Monochromateur selon les revendications 18 et 19,
**caractérisé en ce que**
les électrodes (24, 25) présentent des blindages en forme de caisson sur le potentiel extracteur avec des ouvertures de passage pour le flux de particules de charge.

21. Source de rayonnement avec un monochromateur selon l'une des revendications 1 à 20,
**caractérisé en ce**
**qu'**une source de rayon (17) avec une lentille (21) électrostatique et un obturateur (22) pour la régulation et la limitation du flux de particules (23, 23') est disposée en amont du monochromateur (1), la lentille (21) générant une image virtuelle de la source de rayonnement (17), qui se situe derrière l'entrée (16) du monochromateur (1).

Fig.1

Fig.2

Fig.3

Fig.4a

Fig.4b

23

Fig.5a

Fig.5b

Fig.6a

Fig.6b

Fig.7

Fig.7a

Fig.8

Fig.8a

Fig.8b

Fig.9

Fig.9a

Fig.10a

Fig.10b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005031537 A1
- EP 0470299 B1
- US 20040188607 A1
- DE 19633496 B4
- DE 10020382 A1
- DE 10252129 A1
- US 3863068 A
- EP 0470299 A

**In der Beschreibung aufgeführte Nicht-Patentliteratur**

- A double wienfilter as a high resolution, high transmission electron energy analyser. **W H J Andersen ; J B Le Pool.** Journal of Physics e. Scientific Instruments. IOP Publishing, 01. Februar 1970, vol. 3, 121-126